(19) Europäisches Patentamt
European Patent Office
Office européen des brevets

(11) EP 4 299 653 A1

(12) **EUROPEAN PATENT APPLICATION**
published in accordance with Art. 153(4) EPC

(43) Date of publication:
**03.01.2024 Bulletin 2024/01**

(21) Application number: **22759732.5**

(22) Date of filing: **24.02.2022**

(51) International Patent Classification (IPC):
***C08J 3/22*** *(2006.01)* ***C08K 7/06*** *(2006.01)*
***C08L 25/04*** *(2006.01)* ***C08L 67/02*** *(2006.01)*
***C08L 101/00*** *(2006.01)* ***C08J 5/18*** *(2006.01)*
***H01B 1/24*** *(2006.01)* ***H01B 5/16*** *(2006.01)*
***C08K 3/01*** *(2018.01)* ***C08K 3/04*** *(2006.01)*
***H05K 9/00*** *(2006.01)*

(52) Cooperative Patent Classification (CPC):
(C-Sets available)
**C08K 3/041; C08J 3/22; C08J 5/18; C08K 3/01; C08K 3/04; C08K 7/06; C08L 25/04; C08L 67/02; C08L 101/00; H01B 1/24; H01B 5/16; H05K 9/00**

(Cont.)

(86) International application number:
**PCT/JP2022/007629**

(87) International publication number:
**WO 2022/181697 (01.09.2022 Gazette 2022/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **25.02.2021 JP 2021028685**
**25.02.2021 JP 2021028686**
**25.02.2021 JP 2021028687**
**25.02.2021 JP 2021028688**
**16.12.2021 JP 2021204657**

(71) Applicant: **Mitsubishi Engineering-Plastics Corporation**
**Tokyo 105-0021 (JP)**

(72) Inventors:
- **ISEKI Shuta**
  **Hiratsuka-shi, Kanagawa 254-0016 (JP)**
- **SHOJI Hidekazu**
  **Hiratsuka-shi, Kanagawa 254-0016 (JP)**
- **KITAGAWA Satomi**
  **Hiratsuka-shi, Kanagawa 254-0016 (JP)**

(74) Representative: **Hoffmann Eitle**
**Patent- und Rechtsanwälte PartmbB**
**Arabellastraße 30**
**81925 München (DE)**

# (54) RESIN COMPOSITION, MOLDED BODY, AND ELECTROMAGNETIC WAVE ABSORBER

(57) To provide a resin composition, a formed article, and, an electromagnetic wave absorber, all having large absorbance of electromagnetic wave. The resin composition contains: a thermoplastic resin; and an electro-conductive substance, the resin composition, when formed to a 2 mm thick test specimen and a cross section thereof is observed under a digital microscope, giving an aggregate attributable to the electro-conductive substance, with an area percentage of the aggregate, having an equivalent circle diameter of 30 μm or larger, of 0.80% or smaller.

EP 4 299 653 A1

(52) Cooperative Patent Classification (CPC): (Cont.)

C-Sets
**C08L 67/02, C08K 3/041, C08L 67/02**

## Description

TECHNICAL FIELD

This invention relates to a resin composition, a formed article, and, an electromagnetic wave absorber.

BACKGROUND ART

Millimeter-wave radar detects presence of an obstacle, or distance or speed relative to an object, by emitting radio wave in the millimeter waveband with 1 to 10 mm wavelength, at a frequency of 30 to 300 GHz, particularly from 60 to 90 GHz, and by detecting a reflected wave returned back after colliding on the object. The millimeter-wave radar has been investigated for use in a wide range of fields, including automotive anti-collision sensor, autonomous driving system, road information service system, security system, and medical/care device.

Known examples of resin composition used for such millimeter-wave radar have been described in Patent Literature 1. On the other hand, Patent Literature 2 discloses a multifunctional resin composition applicable for the purpose of shielding electromagnetic interference or shielding radio frequency interference.

CITATION LIST

PATENT LITERATURE

[Patent Literature 1] JP 2019-197048 A
[Patent Literature 2] JP 2010-155993 A

SUMMARY OF THE INVENTION

TECHNICAL PROBLEM

Now, the millimeter-wave radar is most largely affected by transmissive electromagnetic wave to cause malfunction. The resin composition has therefore been required to demonstrate large absorbance of electromagnetic wave.

This invention is aimed at solving the problems, wherein an object of which is to provide a resin composition, a formed article, and, an electromagnetic wave absorber, all having large absorbance of electromagnetic wave.

SOLUTION TO PROBLEM

The present inventors conducted research to address the above-mentioned problems, and as a result, discovered that the absorbance of electromagnetic wave could be lowered by reducing a big aggregate attributable to an electro-conductive substance in the resin composition, a thermoplastic resin blended with the electro-conductive substance.

Specifically, the problems described above are solved by the following means.

<1-1> A resin composition comprising: a thermoplastic resin; and an electro-conductive substance, the resin composition, when formed to a 2 mm thick test specimen and a cross section thereof is observed under a digital microscope, giving an aggregate attributable to the electro-conductive substance, with an area percentage of the aggregate, having an equivalent circle diameter of 30 μm or larger, of 0.80% or smaller.

<1-2> The resin composition of <1-1>, wherein the electro-conductive substance contains a carbon nanotube.

<1-3> The resin composition of <1-1> or <1-2>, wherein the thermoplastic resin contains a polybutylene terephthalate resin.

<1-4> The resin composition of any one of <1-1> to <1-3>, wherein the content of the electro-conductive substance in the resin composition is 0.01 to 10% by mass.

<1-5> The resin composition of <1-1>, wherein the thermoplastic resin contains a polybutylene terephthalate resin; the electro-conductive substance contains a carbon nanotube; and the content of the electro-conductive substance in the resin composition is 0.01 to 10% by mass.

<1-6> The resin composition of <1-1>, wherein the thermoplastic resin contains a polybutylene terephthalate resin and a polystyrene-based resin, and the electro-conductive substance contains a carbon nanotube.

<1-7> The resin composition of <1-6>, wherein the content of the carbon nanotube in the resin composition is 0.01

to 10% by mass.

<1-8> The resin composition of <1-6> or <1-7>, wherein the resin composition demonstrates a sea-island structure having a sea region where the polybutylene terephthalate resin is abundant, and an island region where the polystyrene-based resin is abundant, in which 30% by mass or more of the resin component contained in the resin composition is attributable to the polybutylene terephthalate resin, and the content of the carbon nanotube contained in the sea region is larger than the content of the carbon nanotube contained in the island region.

<1-9> The resin composition of any one of <1-6> to <1-8>, wherein the polystyrene-based resin is attributable to a masterbatch of the carbon nanotube.

<1-10> The resin composition of any one of <1-1> to <1-9>, wherein the electro-conductive substance contains a carbon nanotube, and the resin composition demonstrates a dielectric constant at 76.5 GHz frequency of 4.50 or larger.

<1-11> The resin composition of <1-10>, demonstrating a dielectric loss tangent at 76.5 GHz frequency of 0.10 or larger.

<1-12> The resin composition of <1-10> or <1-11>, wherein the content of the carbon nanotube in the resin composition is 0.01 to 10% by mass.

<1-13> The resin composition of any one of <1-10> to <1-12>, wherein the thermoplastic resin contains a thermoplastic resin (A) and a thermoplastic resin (B), with a content of the thermoplastic resin (B) of 1.0 to 100 parts by mass, per 100 parts by mass of the thermoplastic resin (A).

<1-14> The resin composition of <1-13>, wherein the thermoplastic resin (A) contains a polyester resin.

<1-15> The resin composition of <1-14>, wherein the polyester resin contains a polybutylene terephthalate resin.

<1-16> The resin composition of any one of <1-13> to <1-15>, wherein the thermoplastic resin (B) contains a polystyrene-based resin.

<1-17> The resin composition of any one of <1-13> to <1-16>, wherein at least a part of the thermoplastic resin (B) is attributable to a masterbatch of the carbon nanotube.

<1-18> The resin composition of <1-17>, wherein the concentration of the carbon nanotube in the masterbatch is 1 to 50% by mass.

<1-19> The resin composition of any one of <1-1> to <1-18>, demonstrating an absorbance at 76.5 GHz frequency of 50.0 to 100%, when formed to a thickness of 2 mm, and determined by Equation (A):

Equation (A)

$$\text{Absorbance} \quad (\%) = 100 - \left(\frac{1}{10^{-R/10}} \times 100 + \frac{1}{10^{-T/10}} \times 100\right)$$

(in Equation (A), R represents return loss measured by the free space method, and T represents transmission attenuation measured by the free space method).

<1-20> The resin composition of any one of <1-1> to <1-19>, demonstrating a reflectance at 76.5 GHz frequency of 40.0% or smaller, when formed to a thickness of 2 mm, and determined by Equation (B):

Equation (B)

$$\text{Reflectance} \quad (\%) = \frac{1}{10^{-R/10}} \times 100$$

(in Equation (B), R represents return loss measured by the free space method).

<1-21> The resin composition of any one of <1-1> to <1-20>, demonstrating a transmittance at 76.5 GHz frequency of 25.0% or smaller, when formed to a thickness of 2 mm, and determined by Equation (C):

Equation (C)

$$\text{Transmittance } (\%) = \frac{1}{10^{-T/10}} \times 100$$

(in Equation (C), T represents transmission attenuation measured by the free space method).
<1-22> The resin composition of any one of <1-1> to <1-21>, demonstrating a surface resistivity of $1.0 \times 10^8$ Ω or larger, when formed to a thickness of 2 mm, and measured in compliance with IEC60093.
<1-23> The resin composition of any one of <1-1> to <1-22>, used for an electromagnetic wave absorber.
<1-24> A formed article formed of the resin composition described in any one of <1-1> to <1-23>.
<1-25> An electromagnetic wave absorber formed of the resin composition described in any one of <1-1> to <1-23>.
<1-26> A method for producing a resin composition, the method comprising melt-kneading a polybutylene terephthalate resin, and a masterbatch of a carbon nanotube in a styrene-based resin.
<1-27> The method for producing a resin composition of <1-26>, wherein the resin composition is the resin composition described in any one of <1-6> to <1-9>.
<1-28> The method for producing a resin composition of any one of <1-10> to <1-18>, the method comprising melt-kneading the thermoplastic resin, and the masterbatch of the carbon nanotube in the thermoplastic resin.
<1-29> The resin composition of any one of <1-10> to <1-23>, satisfying a requirement described later in any one of <4-1> to <4-12>.
<2-1> A resin composition containing a polybutylene terephthalate resin, a polystyrene-based resin, and a carbon nanotube.
<2-2> The resin composition of <2-1>, wherein the content of the carbon nanotube in the resin composition is 0.01 to 10% by mass.
<2-3> The resin composition <2-1> or <2-2>, demonstrating a sea-island structure that has a sea region where the polybutylene terephthalate resin is abundant, and an island region where the polystyrene-based resin is abundant, in which 30% by mass or more of the resin component contained in the resin composition is attributable to the polybutylene terephthalate resin, and the content of the carbon nanotube contained in the sea region is larger than the content of the carbon nanotube contained in the island region.
<2-4> The resin composition of any one of <2-1> to <2-3>, wherein the polystyrene-based resin is attributable to a masterbatch of the carbon nanotube.
<2-5> The resin composition of any one of <2-1> to <2-4>, demonstrating an absorbance at 76.5 GHz frequency of 50.0 to 100%, when formed to a thickness of 2 mm, and determined by Equation (A):

Equation (A)

$$\text{Absorbance } (\%) = 100 - \left(\frac{1}{10^{-R/10}} \times 100 + \frac{1}{10^{-T/10}} \times 100\right)$$

(in Equation (A), R represents return loss measured by the free space method, and T represents transmission attenuation measured by the free space method).
<2-6> The resin composition of any one of <2-1> to <2-5>, demonstrating a reflectance at 76.5 GHz frequency of 40.0% or smaller, when formed to a thickness of 2 mm, and determined by Equation (B):

Equation (B)

$$\text{Reflectance } (\%) = \frac{1}{10^{-R/10}} \times 100$$

(in Equation (B), R represents return loss measured by the free space method).

<2-7> The resin composition of any one of <2-1> to <2-6>, demonstrating a transmittance at 76.5 GHz frequency of 25.0% or smaller, when formed to a thickness of 2 mm, and determined by Equation (C):

Equation (C)

$$\text{Transmittance } (\%) = \frac{1}{10^{-T/10}} \times 100$$

(in Equation (C), T represents transmission attenuation measured by the free space method).
<2-8> The resin composition of any one of <2-1> to <2-7>, wherein the carbon nanotube contains a multi-layered carbon nanotube.
<2-9> The resin composition of any one of <2-1> to <2-8>, wherein the polystyrene-based resin contains a butadiene rubber-containing polystyrene.
<2-10> The resin composition of any one of <2-1> to <2-9>, intended for use as an electromagnetic wave absorber.
<2-11> A formed article formed of the resin composition described in any one of <2-1> to <2-10>.
<2-12> An electromagnetic wave absorber formed of the resin composition described in any one of <2-1> to <2-10>.
<2-13> A method for producing a resin composition, the method including melt-kneading a polybutylene terephthalate resin, and a masterbatch of a carbon nanotube in a styrene-based resin.
<2-14> The method for producing a resin composition of <2-13>, wherein the resin composition is the resin composition described in any one of <2-1> to <2-10>.
<3-1> A resin composition comprising: a thermoplastic resin; and a carbon nanotube, the resin composition demonstrating a dielectric constant at 76.5 GHz frequency of 4.50 or larger.
<3-2> The resin composition of <3-1>, demonstrating a dielectric loss tangent at 76.5 GHz frequency of 0.10 or larger.
<3-3> The resin composition of <3-1> or <3-2>, wherein the content of the carbon nanotube in the resin composition is 0.01 to 10% by mass.
<3-4> The resin composition of any one of <3-1> to <3-3>, wherein the thermoplastic resin contains a thermoplastic resin (A) and a thermoplastic resin (B), with a content of the thermoplastic resin (B) of 1.0 to 100 parts by mass, per 100 parts by mass of the thermoplastic resin (A).
<3-5> The resin composition of <3-4>, wherein the thermoplastic resin (A) contains a polyester resin.
<3-6> The resin composition of <3-5>, wherein the polyester resin contains a polybutylene terephthalate resin.
<3-7> The resin composition of any one of <3-4> to <3-6>, wherein the thermoplastic resin (B) contains a polystyrene-based resin.
<3-8> The resin composition of any one of <3-4> to <3-7>, wherein at least a part of the thermoplastic resin (B) is attributable to a masterbatch of the carbon nanotube.
<3-9> The resin composition of <3-8>, wherein the concentration of the carbon nanotube in the masterbatch is 1 to 50% by mass.
<3-10> The resin composition of any one of <3-1> to <3-9>, demonstrating an absorbance at 76.5 GHz frequency of 50.0 to 100%, when formed to a thickness of 2 mm, and determined by Equation (A):
Equation (A):

Equation (A)

$$\text{Absorbance } (\%) = 100 - \left(\frac{1}{10^{-R/10}} \times 100 + \frac{1}{10^{-T/10}} \times 100\right)$$

(in Equation (A), R represents return loss measured by the free space method, and T represents transmission attenuation measured by the free space method).
<3-11> The resin composition of any one of <3-1> to <3-10>, demonstrating a reflectance at 76.5 GHz frequency of 40.0% or smaller, when formed to a thickness of 2 mm, and determined by Equation (B):

Equation (B)

$$\text{Reflectance } (\%) = \frac{1}{10^{-R/10}} \times 100$$

(in Equation (B), R represents return loss measured by the free space method).
<3-12> The resin composition of any one of <3-1> to <3-11>, demonstrating a transmittance at 76.5 GHz frequency of 25.0% or smaller, when formed to a thickness of 2 mm, and determined by Equation (C):

Equation (C)

$$\text{Transmittance } (\%) = \frac{1}{10^{-T/10}} \times 100$$

(in Equation (C), T represents transmission attenuation measured by the free space method).
<3-13> The resin composition of any one of <3-1> to <3-12>, being intended for use as an electromagnetic wave absorber.
<3-14> A formed article formed of the resin composition described in any one of <3-1> to <3-13>.
<3-15> An electromagnetic wave absorber formed of the resin composition described in any one of <3-1> to <3-13>.
<3-16> A method for producing a resin composition described in any one of <3-1> to <3-13>, the method comprising melt-kneading a thermoplastic resin, and a masterbatch of a carbon nanotube in a thermoplastic resin.
<4-1> A resin composition containing a thermoplastic resin (A), a thermoplastic resin (B), and a carbon nanotube, at least a part of the thermoplastic resin (B) is attributable to a masterbatch of the carbon nanotube, and an SP value of the thermoplastic resin (A) is equal to or larger than an SP value of the thermoplastic resin (B) (where, the SP value denotes a solubility parameter).
<4-2> The resin composition of <4-1>, wherein the concentration of the carbon nanotube in the masterbatch is 1 to 50% by mass.
<4-3> The resin composition of <4-1> or <4-2>, wherein the thermoplastic resin (A) is selected from polyester resin, polycarbonate resin and polyamide resin.
<4-4> The resin composition of any one of <4-1> to <4-3>, wherein the thermoplastic resin (B) is selected from polyester resin, polystyrene-based resin and polyolefin resin.
<4-5> The resin composition of any one of <4-1> to <4-4>, wherein difference between the SP value of the thermoplastic resin (A) and the SP value of the thermoplastic resin (B) is 0 to 8.0.
<4-6> The resin composition of any one of <4-1> to <4-4>, wherein difference between the SP value of the thermoplastic resin (A) and the SP value of the thermoplastic resin (B) is 0.1 to 8.0.
<4-7> The resin composition of any one of <4-1> to <4-6>, wherein the content of the carbon nanotube in the resin composition is 0.01 to 10% by mass.
<4-8> The resin composition of any one of <4-1> to <4-7>, demonstrating an absorbance at 76.5 GHz frequency of 50.0 to 100%, when formed to a thickness of 2 mm, and determined by Equation (A):

Equation (A)

$$\text{Absorbance } (\%) = 100 - \left(\frac{1}{10^{-R/10}} \times 100 + \frac{1}{10^{-T/10}} \times 100\right)$$

(in Equation (A), R represents return loss measured by the free space method, and T represents transmission attenuation measured by the free space method).
<4-9> The resin composition of any one of <4-1> to <4-8>, demonstrating a reflectance at 76.5 GHz frequency of 40.0% or smaller, when formed to a thickness of 2 mm, and determined by Equation (B):

Equation (B)

$$\text{Reflectance}\ (\%) = \frac{1}{10^{-R/10}} \times 100$$

(in Equation (B), R represents return loss measured by the free space method).
<4-10> The resin composition of any one of <4-1> to <4-9>, demonstrating a transmittance at 76.5 GHz frequency of 25.0% or smaller, when formed to a thickness of 2 mm, and determined by Equation (C):

Equation (C)

$$\text{Transmittance}\ (\%) = \frac{1}{10^{-T/10}} \times 100$$

(in Equation (C), T represents transmission attenuation measured by the free space method).
<4-11> The resin composition of any one of <4-1> to <4-10>, containing 1.0 to 100 parts by mass of the thermoplastic resin (B), per 100 parts by mass of the thermoplastic resin (A).
<4-12> The resin composition of any one of <4-1> to <4-11>, intended for use as an electromagnetic wave absorber.
<4-13> A formed article formed of the resin composition described in any one of <4-1> to <4-12>.
<4-14> An electromagnetic wave absorber formed of the resin composition described in any one of <4-1> to <4-12>.
<4-15> A method for producing the resin composition, the method including melt-kneading a thermoplastic resin (A), and a masterbatch of a carbon nanotube in a thermoplastic resin (B), and an SP value of the thermoplastic resin (A) is equal to or larger than an SP value of the thermoplastic resin (B) (where, the SP value denotes a solubility parameter).
<4-16> The method for producing a resin composition of <4-15>, wherein the resin composition is the resin composition described in any one of <4-1> to <4-12>.

## ADVANTAGEOUS EFFECTS OF INVENTION

This invention is the first to provide a resin composition, a formed article, and, an electromagnetic wave absorber, all having large absorbance of electromagnetic wave.

## BRIEF DESCRIPTION OF DRAWINGS

[Fig. 1] An electron micrograph of a test specimen observed in Example 1.

## DESCRIPTION OF EMBODIMENTS

Embodiments for carrying out the invention (simply referred to as "this embodiment", hereinafter) will be detailed below. The embodiments below are merely illustrative, so that this invention is not limited solely to these embodiments.
Note that all numerical ranges given in this patent specification, with "to" preceded and succeeded by numerals, are used to represent the ranges including these numerals respectively as the lower and upper limit values.
Various physical properties and characteristic values mentioned herein are those demonstrated at 23°C, unless otherwise specifically noted.
Weight-average molecular weight and number-average molecular weight mentioned herein are polystyrene equivalent values measured by GPC (gel permeation chromatography).
Return loss and transmission attenuation mentioned herein are in dB (decibel).
All standards described herein are those as of January 1, 2021 unless otherwise specifically noted, although some of the methods thereof might be modified depending on the year.
The resin composition of this embodiment contains a thermoplastic resin, and an electro-conductive substance. The resin composition, when formed to a 2 mm thick test specimen and a cross section thereof is observed under a

digital microscope, gives an aggregate attributable to the electro-conductive substance, with an area percentage of the aggregate, having an equivalent circle diameter of 30 μm or larger, of 0.80% or smaller. With the percentage of the aggregate, attributable to the electro-conductive substance and larger than a predetermined size, suppressed to a low level, the absorptivity of electromagnetic wave may be notably enhanced. This also reduces the transmittance and reflectance of electromagnetic wave. Moreover, a formed article formed of the resin composition of this embodiment may have enhanced mechanical strength.

Possible method for reducing the percentage of the aggregate attributable to the electro-conductive substance is exemplified by through dispersion of the electro-conductive substance in the thermoplastic resin. More specifically, the possible method is exemplified by thorough melt-kneading of a blend of the thermoplastic resin and the electro-conductive substance; portion-wise addition of the electro-conductive substance, when melt-kneading the thermoplastic resin and the electro-conductive substance; blending, with the thermoplastic resin, of a dispersion aid for enhancing dispersibility of the electro-conductive substance; blending of the electro-conductive substance in the form of masterbatch with the thermoplastic resin, so as to enhance the dispersibility making use of driving force of the electro-conductive substance that disperses from the masterbatch towards the thermoplastic resin during melt-kneading; and, choice of the electro-conductive substance having a shape advantageous for dispersion. For particularly effective dispersion, two or more techniques among them are preferably selected.

In this embodiment, the area percentage of the aggregate, which is attributable to the electro-conductive substance, and has an equivalent circle diameter of 30 μm or larger, is preferably 0.70% or smaller, more preferably 0.60% or smaller, even more preferably 0.50% or smaller, and yet more preferably 0.42% or smaller. The lower limit value of the area percentage, which is ideally 0%, is practically 0.01% or above. Even a level of 0.10% or above is enough for satisfying the performance requirement.

The area percentage may be measured according to the description later in EXAMPLES.

<Thermoplastic Resin>

The resin composition of this embodiment contains a thermoplastic resin.

Preferred thermoplastic resin used in this embodiment is preferably exemplified by polyester resin (thermoplastic polyester resin); polyamide resin; polycarbonate resin; polystyrene-based resin; polyolefin resins such as polyethylene resin, polypropylene resin, and cycloolefin resin; polyacetal resin; polyimide resin; polyetherimide resin; polyurethane resin; polyphenylene ether resin; polyphenylene sulfide resin; polysulfone resin; and polymethacrylate resin. Polyester resin (thermoplastic polyester resin), polyamide resin, polycarbonate resin, and polyphenylene ether resin are preferred.

In this embodiment, the thermoplastic resin [for example, polyester resin (thermoplastic polyester resin), polyamide resin, polycarbonate resin and polyphenylene ether resin] may be either straight-chain polymer, or branched polymer having a branched structure. The thermoplastic resin in this embodiment preferably has few branched structure. For example, the thermoplastic resin used in this embodiment preferably has a degree of branching (DB) of smaller than 10%, which is more preferably 5% or smaller, and even more preferably 3% or smaller. Now, the degree of branching is defined by DB (%) = $100\times(T+Z)/(T+Z+L)$, where T represents an average number of terminal-bound monomer unit, Z represents an average number of dendric unit, and L represents an average number of linearly-bound unit (within macromolecule of each substance).

The thermoplastic resin in this embodiment preferably contains a polyester resin, and more preferably contains polybutylene terephthalate resin. In this embodiment, preferably 90% by mass or more, and more preferably 93% by mass or more of the thermoplastic resin is attributable to polyester resin.

The thermoplastic resin also preferably contains a polyester resin (preferably polybutylene terephthalate resin) and a polystyrene-based resin. In this embodiment, preferably 90% by mass or more, more preferably 95% by mass or more, and even more preferably 99% by mass or more of the thermoplastic resin is formed of the polyester resin (preferably polybutylene terephthalate resin) and the polystyrene-based resin (preferably HIPS, and more preferably butadiene rubber-containing polystyrene).

The individual thermoplastic resins will be detailed below.

<<Polyester Resin>>

The polyester resin used herein may be any of known thermoplastic polyester resins, which is preferably polyethylene terephthalate resin or polybutylene terephthalate resin, and preferably contains at least polybutylene terephthalate resin.

The polybutylene terephthalate resin used for the resin composition of this embodiment has a structure in which terephthalic acid unit and 1,4-butanediol unit form an ester bond in between, and includes not only such polybutylene terephthalate resin (homopolymer), but also polybutylene terephthalate copolymer that contains a copolymer component other than the terephthalic acid unit and the 1,4-butanediol unit; and mixture of the homopolymer and the polybutylene

terephthalate copolymer.

The polybutylene terephthalate resin may contain one kind, or two or more kinds of dicarboxylic acid unit other than terephthalic acid.

Such other dicarboxylic acid is specifically exemplified by aromatic dicarboxylic acids such as isophthalic acid, orthophthalic acid, 1,5-naphthalenedicarboxylic acid, 2,5-naphthalenedicarboxylic acid, 2,6-naphthalenedicarboxylic acid, biphenyl-2,2'-dicarboxylic acid, biphenyl-3,3'-dicarboxylic acid, biphenyl-4,4'-dicarboxylic acid, bis(4,4'-carboxyphenyl)methane, anthracene dicarboxylic acid, and 4,4'-diphenyl ether dicarboxylic acid; alicyclic dicarboxylic acids such as 1,4-cyclohexanedicarboxylic acid, and 4,4'-dicyclohexyldicarboxylic acid; and aliphatic dicarboxylic acids such as adipic acid, sebacic acid, azelaic acid, and dimer acid.

In the polybutylene terephthalate resin used in this embodiment, the terephthalic acid unit preferably accounts for 80 mol% or more of all dicarboxylic acid units, more preferably accounts for 90 mol% or more, even more preferably accounts for 95 mol% or more, yet more preferably accounts for 97 mol% or more, and furthermore preferably accounts for 99 mol% or more.

One kind of, or two or more kinds of other diol unit may be contained as the diol unit, besides 1,4-butanediol.

Such other diol unit is specifically exemplified by aliphatic or alicyclic diols having 2 to 20 carbon atoms, and bisphenol derivatives. Specific examples include ethylene glycol, propylene glycol, 1,5-pentanediol, 1,6-hexanediol, neopentyl glycol, decamethylene glycol, cyclohexanedimethanol, 4,4'-dicyclohexylhydroxymethane, 4,4'-dicyclohexylhydroxypropane, and bisphenol A-ethylene oxide adduct. Again besides the aforementioned bifunctional monomers, also usable in a small amount are trifunctional monomers such as trimellitic acid, trimesic acid, pyromellitic acid, pentaerythritol, trimethylolpropane for the purpose of introducing a branching structure; and monofunctional compound such as fatty acid for controlling the molecular weight.

In the polybutylene terephthalate resin used in this embodiment, the 1,4-butanediol unit preferably accounts for 80 mol% or more of all diol units, more preferably accounts for 90 mol% or more, even more preferably accounts for 95 mol% or more, yet more preferably accounts for 97 mol% or more, and furthermore preferably accounts for 99 mol% or more.

The polybutylene terephthalate resin is preferably a polybutylene terephthalate homopolymer obtainable by polycondensing terephthalic acid with 1,4-butanediol, as described previously. Also acceptable is the polybutylene terephthalate copolymer that contains one or more kinds of dicarboxylic acid other than terephthalic acid as the carboxylic acid unit, and/or, one or more kinds of diol other than 1,4-butanediol as the diol unit. In a case where the polybutylene terephthalate resin is modified by copolymerization, preferred examples of such copolymer include polyester ether resin copolymerized with polyalkylene glycols, specifically with polytetramethylene glycol; polybutylene terephthalate resin copolymerized with dimer acid; and polybutylene terephthalate resin copolymerized with isophthalic acid. Among them, polyester ether resin copolymerized with polytetramethylene glycol is preferably used.

Note that these copolymers are defined to have an amount of copolymerization of 1 mol% or more and less than 50 mol%, relative to all segments of the polybutylene terephthalate resin. In particular, the amount of copolymerization is preferably 2 mol% or more and less than 50 mol%, even more preferably 3 to 40 mol%, and yet more preferably 5 to 20 mol%. Such proportion of copolymerization is preferred since the fluidity, toughness, and tracking resistance are more likely to improve.

Terminal carboxy group content of the polybutylene terephthalate resin, which may be subjected to proper choice and decision, is typically 60 eq/ton or less, preferably 50 eq/ton or less, and even more preferably 30 eq/ton or less. At or below the upper limit value, the alkali resistance and hydrolysis resistance tend to improve. The lower limit value of the terminal carboxy group content, although not specifically limited, is normally 10 eq/ton or more, taking productivity of the polybutylene terephthalate resin into consideration.

Note that the terminal carboxy group content of the polybutylene terephthalate resin is a measured value obtainable by dissolving 0.5 g of the polybutylene terephthalate resin into 25 mL of benzyl alcohol, and titrating the solution with a 0.01 mol/L sodium hydroxide solution in benzyl alcohol. Method for controlling the terminal carboxy group content is freely selectable from known methods, including a method for controlling polymerization conditions such as loading ratio of raw materials, polymerization temperature, and decompression scheme; and a method of reacting with a terminal blocker.

The polybutylene terephthalate resin preferably has an intrinsic viscosity of 0.5 dL/g or larger, which is more preferably 0.6 dL/g or larger. With the intrinsic viscosity controlled to 0.5 dL/g or larger, the obtainable resin composition tends to further improve the mechanical strength. The intrinsic viscosity is preferably 2.00 dL/g, more preferably 1.50 dL/g or smaller, even more preferably 1.30 dL/g or smaller, yet more preferably 1.26 dL/g or smaller, furthermore preferably 1.23 dL/g or smaller, and even may be 1.20 dL/g or smaller, 1.17 dL/g or smaller, 1.15 dL/g or smaller, 1.13 dL/g or smaller, 1.07 dL/g or smaller, 1.05 dL/g or smaller, 1.00 dL/g or smaller, and 0.97 dL/g or smaller. With the intrinsic viscosity controlled to 2.0 dL/g or smaller, the resin composition tends to further improve the fluidity, and to improve the formability. In a special case where the masterbatch of the elector-conductive substance (particularly, carbon nanotube) in polybutylene terephthalate resin is blended with the resin composition in which polybutylene terephthalate

resin serves as the major component of the thermoplastic resin (typically accounts for 80% by mass or more of the resin component), the smaller the intrinsic viscosity of the polybutylene terephthalate as the major component, the easier the electro-conductive substance can disperse. This consequently tends to further improve the absorption property of electromagnetic wave.

Note that the intrinsic viscosity of the polybutylene terephthalate resin is a value measured in a 1:1 (mass ratio) mixed solvent of tetrachloroethane and phenol, at 30°C.

The polybutylene terephthalate resin may be produced by batch-type or continuous melt polymerization of a dicarboxylic acid component mainly composed of terephthalic acid or ester derivative thereof, with a diol component mainly composed of 1,4-butanediol. The melt polymerization, after producing a low-molecular-weight polybutylene terephthalate resin, may also be followed by solid phase polymerization under nitrogen gas flow or under reduced pressure, to increase the degree of polymerization (or molecular weight) up to a desired level.

The polybutylene terephthalate resin is preferably obtained by continuous melt polymerization of a dicarboxylic acid component mainly composed of terephthalic acid, with a diol component mainly composed of 1,4-butanediol.

Catalyst used for the esterification may be any of known substances including titanium compound, tin compound, magnesium compound, and calcium compound. Among them, particularly preferred is titanium compound. The titanium compound as an esterification catalyst is specifically exemplified by titanium alcoholate such as tetramethyl titanate, tetraisopropyl titanate, and tetrabutyl titanate; and titanium phenolate such as tetraphenyl titanate.

The polyester resin other than those described above may be understood referring to the description in paragraphs [0013] to [0016] of JP 2010-174223 A, the content of which is incorporated herein by reference.

<<Polystyrene-Based Resin>>

The polystyrene-based resin is exemplified by homopolymer of styrene-based monomer, and copolymer of styrene-based monomer with other monomer copolymerizable with the styrene-based monomer. The styrene-based monomer is exemplified by styrene, $\alpha$-methylstyrene, chlorostyrene, methylstyrene, and *tert*-butylstyrene. In the styrene-based resin in this embodiment, the styrene-based monomer accounts for 50 mol% or more of the monomer unit.

The polystyrene-based resin is more specifically exemplified by resins such as polystyrene resin, acrylonitrile-styrene copolymer (AS resin), high-impact polystyrene-based resin (HIPS), acrylonitrile-butadiene-styrene copolymer (ABS resin), acrylonitrile-acrylic rubber-styrene copolymer (AAS resin), acrylonitrile-styrene-acrylic rubber copolymer (ASA resin), acrylonitrile-ethylene propylene-based rubber-styrene copolymer (AES resin), and styrene-IPN type rubber copolymer.

In this embodiment, the styrene-based resin is preferably acrylonitrile-styrene copolymer (AS resin), impact resistance polystyrene resin (HIPS), acrylonitrile-butadiene-styrene copolymer (ABS resin), acrylonitrile-acrylic rubber-styrene copolymer (AAS resin), acrylonitrile-styrene-acrylic rubber copolymer (ASA resin), acrylonitrile-ethylene propylene-based rubber-styrene copolymer (AES resin), or styrene-IPN type rubber copolymer; more preferably impact resistance polystyrene resin (HIPS); and even more preferably butadiene rubber-containing polystyrene.

The content of the rubber component in the polystyrene-based resin, when contained in the polystyrene-based resin, is preferably 3 to 70% by mass, more preferably 5 to 50% by mass, and even more preferably 7 to 30% by mass. With the content of the rubber component controlled to 3% by mass or more, the impact resistance tends to improve, meanwhile at or below 50% by mass, the flame retardance desirably tends to improve. The rubber component preferably has an average particle size of 0.05 to 10 um, which is more preferably 0.1 to 6 $\mu$m, and even more preferably 0.2 to 3 um. With the average particle size controlled to 0.05 $\mu$m or larger, the impact resistance tends to improve, meanwhile at or below 10 $\mu$m, the appearance desirably tends to improve.

The polystyrene-based resin usually has a weight-average molecular weight of 50,000 or larger, which is preferably 100,000 or larger, more preferably 150,000 or larger, meanwhile, usually 500,000 or smaller, more preferably 400,000 or smaller, and even more preferably 300,000 or smaller. Meanwhile, the number-average molecular weight is usually 10,000 or larger, preferably 30,000 or larger, more preferably 50,000 or larger, meanwhile, preferably 500,000 or smaller, and more preferably 300,000 or smaller.

The polystyrene-based resin preferably has a melt flow rate (MFR), when measured in compliance with JIS K7210 (at 200°C, under 5 kgf load) of 0.1 to 30 g/10 min, which is more preferably 0.5 to 25 g/10 min. With the MFR controlled to 0.1 g/10 min or above, the fluidity tends to improve, meanwhile, with the MFR controlled to 30 g/10 min or below, the impact resistance tends to improve.

Method of producing such polystyrene-based resin is exemplified by known methods including emulsion polymerization, solution polymerization, suspension polymerization, and bulk polymerization.

<<Polycarbonate Resin>>

The polycarbonate resin is an optionally branched homopolymer or copolymer, obtainable by reacting dihydroxy

compound, occasionally together with a small amount of polyhydroxy compound, with phosgene or carbonic acid diester. Method for producing the polycarbonate resin is not specifically limited, so that any of polycarbonate resins produced by known methods including phosgene method (interfacial polymerization) or fusion method (transesterification) may be used.

The dihydroxy compound used as the raw material is preferably an aromatic dihydroxy compound, which is exemplified by 2,2-bis(4-hydroxyphenyl)propane (or, bisphenol A), tetramethylbisphenol A, bis(4-hydroxyphenyl)-p-diisopropyl benzene, hydroquinone, resorcinol, and 4,4-dihydroxybiphenyl. Bisphenol A is preferred. Also the aromatic dihydroxy compound, having one or more tetraalkylphosphonium sulfonates bound thereto, may be used.

Among the aforementioned polycarbonate resins, preferred is aromatic polycarbonate resin derived from 2,2-bis(4-hydroxyphenyl)propane, or, aromatic polycarbonate copolymer derived from 2,2-bis(4-hydroxyphenyl)propane and other aromatic dihydroxy compound. The polycarbonate resin may alternatively be a copolymer mainly composed of an aromatic polycarbonate resin, copolymerized with a polymer or oligomer having a siloxane structure. Still alternatively, two or more kinds of the aforementioned polycarbonate resins may be mixed for use.

The molecular weight of the polycarbonate resin is adjustable simply by using a monohydric aromatic hydroxy compound, which is exemplified by *m*- or p-methylphenol, m- or p-propylphenol, p-tert-butylphenol, and phenol substituted by a long chain alkyl group at the p-position.

The polycarbonate resin preferably has a viscosity-average molecular weight (Mv) of 5,000 or larger, which is more preferably 10,000 or larger, and even more preferably 13,000 or larger. With use of the polycarbonate resin having a viscosity-average molecular weight of 5,000 or larger, the obtainable formed article will tend to further improve the mechanical strength. Meanwhile, the polycarbonate resin preferably has a viscosity-average molecular weight (Mv) of 60,000 or smaller, which is more preferably 40,000 or smaller, and even more preferably 30,000 or smaller. At or below 60,000, the resin composition tends to have improved fluidity and improved formability.

When two or more kinds of polycarbonate resin are contained, the mixture preferably satisfies any of the aforementioned ranges (the same will apply hereinafter to the molecular weight).

Note, the viscosity-average molecular weight (Mv) of the polycarbonate resin in this embodiment is a value determined by measuring viscosity of a methylene chloride solution of the polycarbonate resin at 20°C with use of an Ubbelohde viscometer to find limiting viscosity ([η]), followed by calculation from the Schnell's viscosity equation below.

$$[\eta] = 1.23\times10^{-4}Mv^{0.83}$$

Method of producing the polycarbonate resin is not specifically limited, so that the polycarbonate produced by either the phosgene method (interfacial polymerization) or the fusion method (transesterification) is usable. A preferred polycarbonate resin is also obtainable by further subjecting the polycarbonate resin, having been produced by the fusion method, to post-treatment for controlling the content of terminal OH group.

<<Polyphenylene Ether Resin>>

This embodiment can use any of known polyphenylene ether resins, which are exemplified typically by a polymer having, as the principal chain thereof, a structural unit represented by the formula below (preferably, a polymer in which a structural unit represented by the formula below accounts for 90 mol% or more of all structural units while excluding the terminal group). The polyphenylene ether resin may be either homopolymer or copolymer.

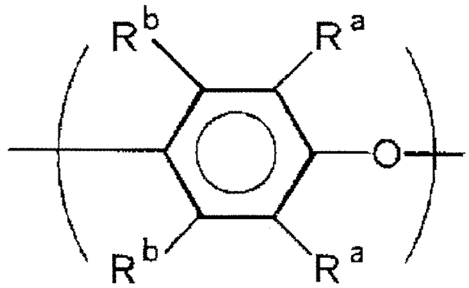

(In the formula, each of two ($R^a$)s independently represents a hydrogen atom, a halogen atom, a primary or secondary alkyl group, an aryl group, an aminoalkyl group, a halogenated alkyl group, a hydrocarbonoxy group, or a halogenated hydrocarbonoxy group; each of two ($R^b$)s independently represents a hydrogen atom, a halogen atom, a primary or secondary alkyl group, an aryl group, a halogenated alkyl group, a hydrocarbonoxy group, or halogenated hydrocarbonoxy

group, while excluding a case where two ($R^a$)s concurrently represent hydrogen atoms.)

Each of $R^a$ and $R^b$ independently, and preferably, represents a hydrogen atom, a primary or secondary alkyl group, or an aryl group. Preferred examples of the primary alkyl group include methyl group, ethyl group, n-propyl group, n-butyl group, n-amyl group, isoamyl group, 2-methylbutyl group, 2,3-dimethylbutyl group, 2-, 3- or 4-methylpentyl group, or heptyl group. Preferred examples of the secondary alkyl group include isopropyl group, sec-butyl group, and 1-ethylpropyl group. In particular, $R^a$ preferably represents a primary or secondary alkyl group having 1 to 4 carbon atoms, or a phenyl group. $R^b$ preferably represents a hydrogen atom.

Preferred homopolymer of polyphenylene ether resin is exemplified by polymers of 2,6-dialkyl phenylene ethers, such as poly(2,6-dimethyl-1,4-phenylene ether), poly(2,6-diethyl-1,4-phenylene ether), poly(2,6-dipropyl-1,4-phenylene ether), poly(2-ethyl-6-methyl-1,4-phenylene ether), and poly(2-methyl-6-propyl-1,4-phenylene ether). The copolymer is exemplified by 2,6-dialkylphenol/2,3,6-trialkylphenol copolymers, such as 2,6-dimethylphenol/2,3,6-trimethylphenol copolymer, 2,6-dimethylphenol/2,3,6-triethylphenol copolymer, 2,6-diethylphenol/2,3,6-trimethylphenol copolymer, and 2,6-dipropylphenol/2,3,6-trimethylphenol copolymer; graft copolymer having styrene grafted to poly(2,6-dimethyl-1,4-phenylene ether); and graft copolymer having styrene grafted to 2,6-dimethylphenol/2,3,6-trimethylphenol copolymer.

Particularly preferred polyphenylene ether resin in this embodiment is poly(2,6-dimethyl-1,4-phenylene ether), and 2,6-dimethylphenol/2,3,6-trimethylphenol random copolymer. Also polyphenylene ether resin described in JP 2005-344065 A, in which the number of terminal groups and copper content ratio are specified, is suitably used.

The polyphenylene ether resin preferably has an intrinsic viscosity, when measured in chloroform at 30°C, of 0.2 to 0.8 dL/g, which is more preferably 0.3 to 0.6 dL/g. With the intrinsic viscosity controlled to 0.2 dL/g or larger, the formed article may have further improved mechanical strength, meanwhile at or below 0.8 dL/g, the resin composition tends to further improve the fluidity, making the forming process further easier. These ranges of intrinsic viscosity may also be achieved by combining two or more kinds of polyphenylene ether resin differ in intrinsic viscosity.

The polyphenylene ether resin used for this embodiment may be produced by any of known methods without special limitation, typically by oxidative polymerization of a monomer such as 2,6-dimethylphenol in the presence of amine-copper catalyst. In this process, the intrinsic viscosity is adjustable within a desired range, by properly selecting the reaction conditions. The intrinsic viscosity is controllable by selecting conditions including polymerization temperature, polymerization time, amount of catalyst and so forth.

<<Polyamide Resin>>

The polyamide resin is a polymer having, as a structural unit, acid amide obtainable by ring-opening polymerization of lactam, polycondensation of aminocarboxylic acid, or polycondensation of diamine and dibasic acid, and may be aliphatic polyamide resin or semi-aromatic polyamide resin.

The polyamide resin is specifically exemplified by polyamide 6, 11, 12, 46, 66, 610, 612, 6I, 6/66, 6T/6I, 6/6T, 66/6T, 66/6T/6I, 10T, and later-detailed xylylenediamine-based polyamide resin, poly(trimethyl hexamethylene terephthalamide), polybis(4-aminocyclohexyl)methanedodecamide, polybis(3-methyl-4-aminocyclohexyl)methanedodecamide, and poly(undecamethylene hexahydroterephthalamide). Note that "I" represents an isophthalic acid component, and "T" represents a terephthalic acid component. The polyamide resin may be understood referring to the description in paragraphs [0011] to [0013] of JP 2011-132550 A, the content of which is incorporated herein by reference.

The polyamide resin used in this embodiment contains a diamine-derived structural unit and a dicarboxylic acid-derived structural unit, and is preferably a xylylenediamine-based polyamide resin in which 50 mol% or more of the diamine-derived structural unit is derived from xylylenediamine. In the xylylenediamine-based polyamide resin, preferably 70 mol% or more of the diamine-derived structural unit is derived from at least either metaxylylenediamine or paraxylylenediamine, wherein the percentage is more preferably 80 mol% or larger, even more preferably 90 mol% or larger, and yet more preferably 95 mol% or larger. In the xylylenediamine-based polyamide resin, preferably 50 mol% or more of the dicarboxylic acid-derived structural unit is derived from a straight-chain aliphatic $\alpha,\omega$-dicarboxylic acid having 4 to 20 carbon atoms, wherein the percentage is more preferably 70 mol% or larger, even more preferably 80 mol% or larger, yet more preferably 90 mol% or larger, and furthermore preferably 95 mol% or larger. For use as the straight-chain aliphatic $\alpha,\omega$-dibasic acid having 4 to 20 carbon atoms, preferred are adipic acid, sebacic acid, suberic acid, dodecanedioic acid, and eicosanedioic acid. Adipic acid and sebacic acid are more preferred.

Diamine other than metaxylylenediamine and paraxylylenediamine, usable herein as a raw diamine component of the xylylenediamine-based polyamide resin, is exemplified by aliphatic diamines such as tetramethylenediamine, pentamethylenediamine, 2-methyl pentanediamine, hexamethylenediamine, heptamethylenediamine, octamethylenediamine, nonamethylenediamine, decamethylenediamine, dodecamethylenediamine, 2,2,4-trimethyl-hexamethylenediamine, and 2,4,4-trimethylhexamethylenediamine; alicyclic diamines such as 1,3-bis(aminomethyl)cyclohexane, 1,4-bis(aminomethyl)cyclohexane, 1,3-diaminocyclohexane, 1,4-diaminocyclohexane, bis(4-aminocyclohexyl)methane, 2,2-bis(4-aminocyclohexyl)propane, bis(aminomethyl)decalin, and bis(aminomethyl)tricyclodecane; and aromatic ring-containing diamines such as bis(4-aminophenyl)ether, paraphenylene diamine, and bis(aminomethyl)naphthalene, all

of which may be used singly, or in combination of two or more kinds thereof.

Dicarboxylic acid component other than the straight-chain aliphatic $\alpha,\omega$-dicarboxylic acid having 4 to 20 carbon atoms is exemplified by phthalic acid compound such as isophthalic acid, terephthalic acid, and orthophthalic acid; and naphthalenedicarboxylic acid isomers such as 1,2-naphthalenedicarboxylic acid, 1,3-naphthalenedicarboxylic acid, 1,4-naphthalenedicarboxylic acid, 1,5-naphthalenedicarboxylic acid, 1,6-naphthalenedicarboxylic acid, 1,7-naphthalenedicarboxylic acid, 1,8-naphthalenedicarboxylic acid, 2,3-naphthalenedicarboxylic acid, 2,6-naphthalenedicarboxylic acid, and 2,7-naphthalenedicarboxylic acid, wherein all of them may be used singly, or two or more of them may be used in combination.

Content of the thermoplastic resin in the resin composition of this embodiment is preferably 30% by mass or more in the resin composition, more preferably 35% by mass or more, even more preferably 40% by mass or more, yet more preferably 45% by mass or more, and furthermore preferably 50% by mass or more. In a case where the resin composition does not contain the reinforcing material, the content of the thermoplastic resin in the resin composition is more preferably 60% by mass or more, even more preferably 70% by mass or more, yet more preferably 80% by mass or more, and furthermore preferably 90% by mass or more. At or above the lower limit value, the fluidity during injection molding tends to further improve. Meanwhile, the content of the thermoplastic resin is preferably 99% by mass or less. In a case where the resin composition contains the reinforcing material, the content of the thermoplastic resin in the resin composition is more preferably 90% by mass or less, even more preferably 85% by mass or less, and yet more preferably 80% by mass or less. At or below the upper limit value, the formed article tends to reduce the warpage more effectively.

The resin composition of this embodiment may contain only one kind of, or two or more kinds of thermoplastic resin. When two or more kinds are contained, the total content preferably falls within any of the aforementioned ranges.

<Electro-Conductive Substance>

The resin composition of this embodiment contains an electro-conductive substance. With the electro-conductive substance contained therein, the resin composition may be given absorptivity of electromagnetic wave.

The electro-conductive substance used in this embodiment is exemplified by metal, metal oxide, electro-conductive carbonaceous compound, and electro-conductive polymer. The electro-conductive carbonaceous compound is preferred.

The metal is exemplified by those composed of copper, nickel, silver, or stainless steel, among which metal filler, stainless steel fiber and magnetic filler are preferred. The metal oxide is exemplified by alumina and zinc oxide. Alumina fiber and zinc oxide nanotube are preferred. The electro-conductive carbonaceous compound is preferably carbon black, Ketjen black, graphene, graphite, fullerene, carbon nanocoil, carbon nanotube, and carbon fiber. The carbon nanotube is more preferred.

Also fiber covered with metal, metal oxide, or electro-conductive carbonaceous compound is preferred. Such fiber is exemplified by carbon-coated potassium titanate whisker, and metal-covered fiber.

The electro-conductive substance in this embodiment preferably has a relatively thin and long shape, such as fiber, tube or whisker.

The diameter (number-average fiber diameter) of the electro-conductive substance (preferably, carbon nanotube) is preferably 0.5 nm or longer, more preferably 1 nm or longer, and even more preferably 5 nm or longer. Meanwhile, the diameter (number-average fiber diameter) of the carbon nanotube is preferably 100 nm or shorter, more preferably 50 nm or shorter, even more preferably 30 nm or shorter, and yet more preferably 10 nm or shorter. The aspect ratio of the electro-conductive substance is preferably 5 or larger, from the viewpoint of imparting good absorptivity of electromagnetic wave, which is more preferably 50 or larger. The upper limit value is typically 500 or below, although not particularly specified.

The electro-conductive substance used in this embodiment is preferably a carbon nanotube. The carbon nanotube may be monolayered carbon nanotube and/or multi-layered carbon nanotube, and preferably contains at least the multi-layered carbon nanotube. Also a carbonaceous material partially having a structure of carbon nanotube is applicable. The carbon nanotube may have not only a cylindrical shape, but also a coil shape with a coil pitch of 1 um or smaller.

The carbon nanotube is commercially available, and is exemplified by those available from Bayer MaterialScience AG, Nanocyl S.A., Showa Denko K.K., and Hyperion Catalysis International, Inc. Note that the carbon nanotube is alternatively referred to as graphite fibril or carbon fibril.

The content of the electro-conductive substance (preferably carbon nanotube) in the resin composition of this embodiment is preferably 0.01% by mass or more, more preferably 0.05% by mass or more, even more preferably 0.1% by mass or more, may be 0.2% by mass or more, and even may be 0.4% or more. At or above the lower limit value, the absorptivity of electromagnetic wave may be demonstrated effectively. Meanwhile, the content of the electro-conductive substance (preferably carbon nanotube) in the resin composition of this embodiment is preferably 10% by mass or less,

more preferably 8% by mass or less, even more preferably 6% by mass, yet more preferably 4% by mass or less, furthermore preferably 3% by mass or less, may be 2% by mass or less, and even may be 1% by mass or less. At or below the upper limit value, the resin tends to improve the fluidity.

The resin composition of this embodiment also preferably contains 0.1 parts by mass or more of the electro-conductive substance (preferably carbon nanotube), per 100 parts by mass of the thermoplastic resin. At or above the lower limit value, the absorptivity of electromagnetic wave may be demonstrated effectively. Meanwhile, the resin composition of this embodiment preferably contains 10.0 parts by mass or less of the electro-conductive substance (preferably carbon nanotube), per 100 parts by mass of the thermoplastic resin, the content is more preferably 8.0 parts by mass or less, even more preferably 6.0 parts by mass or less, yet more preferably 4.0 parts by mass or less, furthermore preferably 3.0 parts by mass or less, may be 2.5 parts by mass or less, and particularly may be 1.5 parts by mass or less. At or below the upper limit value, the resin tends to further improve the fluidity.

The resin composition of this embodiment may contain only one kind of, or two or more kinds of the carbon nanotube. When two or more kinds are contained, the total content preferably falls within any of the aforementioned ranges.

<Other Components>

The resin composition of this embodiment may contain some other optional components besides those described previously, without seriously degrading the desired physical properties. Such other components are exemplified by reinforcing material, and various resin additives. Only one of such other components may be contained, or two or more kinds are contained according to freely selectable combination and proportion.

Other components are more specifically exemplified by stabilizer, mold releasing agent, flame retardant, pigment, dye, UV absorber, antistatic agent, anti-clouding agent, anti-blocking agent, flow modifier, plasticizer, dispersion aid, and antibacterial agent. The resin composition of this embodiment preferably contains at least either stabilizer or mold releasing agent.

The resin composition of this embodiment is prepared so that the thermoplastic resin, the electro-conductive substance, and the other optionally blended component will total 100% by mass. In the resin composition of this embodiment, also the total of the thermoplastic resin, the electro-conductive substance, the stabilizer, and the mold releasing agent preferably accounts for 99% by mass or more of the resin composition. Moreover in the resin composition of this embodiment, also the total of the thermoplastic resin, the electro-conductive substance, the reinforcing material (preferably glass fiber), the stabilizer, and the mold releasing agent preferably accounts for 99% by mass or more of the resin composition.

<<Stabilizer>>

The resin composition of this embodiment may contain a stabilizer. The stabilizer is exemplified by hindered phenol-based compound, hindered amine-based compound, phosphorus-containing compound, and sulfur-containing stabilizer. Among them, preferred is hindered phenol-based compound. Combined use of the hindered phenol-based compound and the phosphorus-containing compound is also preferred.

The stabilizer may be understood referring to the description in paragraphs [0046] to [0057] of JP 2018-070722 A, description in paragraphs [0030] to [0037] of JP 2019-056035 A, and description in paragraphs [0066] to [0078] of WO 2017/038949, the contents of which are incorporated herein by reference.

The resin composition of this embodiment preferably contains 0.01 parts by mass or more of the stabilizer, per 100 parts by mass of the thermoplastic resin, wherein the content is more preferably 0.05 parts by mass or more, and even more preferably 0.08 parts by mass or more. The upper limit value of the content of the stabilizer is preferably 3 parts by mass or below, per 100 parts by mass of the thermoplastic resin, which is more preferably 2 parts by mass or below, and even more preferably 1 part by mass or below.

The resin composition of this embodiment may contain only one kind of, or two or more kinds of the stabilizer. When two or more kinds are contained, the total content preferably falls within any of the aforementioned ranges.

<<Mold Releasing Agent>>

The resin composition of this embodiment preferably contains a mold releasing agent.

A wide range of known mold releasing agent is applicable, among which esterified product of aliphatic carboxylic acid, paraffin wax, and polyethylene wax are preferred. Polyethylene wax is more preferred.

The mold releasing agent may be understood referring to the descriptions in paragraphs [0115] to [0120] of JA 2013-007058 A, in paragraphs [0063] to [0077] of JA 2018-070722 A, and in paragraphs [0090] to [0098] of JA 2019-123809 A, the contents of which are incorporated herein by reference.

The resin composition of this embodiment preferably contains 0.01 parts by mass or more of the mold releasing agent, per 100 parts by mass of the thermoplastic resin, wherein the content is more preferably 0.08 parts by mass or more, and even more preferably 0.2 parts by mass or more. The upper limit value of the content of the mold releasing agent is preferably 5 parts by mass or below, per 100 parts by mass of the thermoplastic resin, more preferably 3 parts by mass or below, even more preferably 1 part by mass or below, and yet more preferably 0.8 parts by mass or below.
The resin composition may contain only one kind of, or two or more kinds of the mold releasing agent. When two or more kinds are contained, the total content preferably falls within any of the aforementioned ranges.

<Reinforcing Material>

The resin composition of this embodiment may contain a reinforcing material, but not necessarily. With the reinforcing material contained therein, the obtainable formed article may have improved mechanical strength.
The reinforcing material usable in this embodiment may be any of fiber, filler and bead, without special limitation on the types and so forth, wherein fiber is preferred.
In particular, use of the glass fiber is preferred, since the glass fiber can also function as a dispersion aid for the electro-conductive substance. Note that any substance that applies both to the electro-conductive substance and the reinforcing material is categorized herein as the electro-conductive substance.
The reinforcing material, if in the form of fiber, may be either staple fiber or filament yarn.
In a case where the reinforcing material is any of staple fiber, filler, bead or the like, the resin composition of this embodiment is exemplified by those in the form of pellet, pulverized pellet, and film formed from such pellet.
The reinforcing material, if in the form of filament yarn, is exemplified by filament yarn for so-called unidirectional (UD) material, and sheet-like filament yarn which is woven or knitted. When using such filament yarn, the component of the resin composition of this embodiment, other than the reinforcing material, may be impregnated into the reinforcing material in such form of sheet-like filament yarn, to produce a sheet-like resin composition (prepreg, for example).
Raw material of the reinforcing material is exemplified by inorganic materials such as glass, carbon (carbon fiber, etc.), alumina, boron, ceramic, and metal (steel, etc.); and organic materials such as plant (including kenaf, bamboo, etc.), aramid, polyoxymethylene, aromatic polyamide, poly(paraphenylene benzobisoxazole), and ultrahigh molecular weight polyethylene. Glass is preferred.
The resin composition of this embodiment preferably contains a glass fiber as the reinforcing material.
The glass fiber is selectable from those having glass composition of A-glass, C-glass, E-glass, R-glass, D-glass, M-glass, S-glass and so forth. E-glass (non-alkali glass) is particularly preferred.
The glass fiber is defined as an article that looks fibrous, and has an exact circular or polygonal cross section perpendicular to the longitudinal direction. The glass fiber normally has a number-average fiber diameter of monofilament of 1 to 25 um, which is preferably 5 to 17 um. With the number-average fiber diameter adjusted to 1 μm or larger, the resin composition tends to further improve the formability. With the number-average fiber diameter adjusted to 25 um or smaller, the obtainable formed article may have improved appearance, and may tend to enhance the reinforcing effect. The glass fiber may be a monofilament, or a twisted yarn formed of a plurality of monofilaments.
Product form of the glass fiber may be any of "glass roving" which is a roll on which a monofilament or twisted yarn made of a plurality of monofilaments are continuously wound, "chopped strand" cut into 1 to 10 mm length (that is, glass fiber having a number-average fiber length of 1 to 10 mm), and "milled fiber" ground into 10 to 500 um length (that is, glass fiber having a number-average fiber length of 10 to 500 μm). The chopped strand uniformly cut into 1 to 10 mm length is preferred. Also glass fibers with different morphologies may be used in a combined manner.
Also glass fibers having modified cross sectional shapes are preferred. The modified cross sectional shape is typically represented by an oblateness, which is defined by a long diameter-to-short diameter proportion of a cross section perpendicular to the longitudinal direction of the fiber, of 1.5 to 10, which is preferably 2.5 to 10, more preferably 2.5 to 8, and particularly preferably 2.5 to 5.
For the purpose of improving affinity with the resin component, the glass fiber may be surface-treated typically with a silane-based compound, epoxy-based compound, or urethane-based compound, or may be subjected to oxidation treatment, without largely degrading properties of the resin composition of this embodiment.
In the resin composition of this embodiment, the content of the reinforcing material (preferably glass fiber), if contained, is preferably 10 parts by mass or more, per 100 parts by mass of the thermoplastic resin, more preferably 20 parts by mass or more, even more preferably 30 parts by mass or more, and yet more preferably 40 parts by mass or more. At or above the lower limit value, the obtainable formed article tends to further enhance the mechanical strength. Meanwhile, the content of the reinforcing material (preferably glass fiber) is preferably 100 parts by mass or less, per 100 parts by mass of the thermoplastic resin, more preferably 90 parts by mass or less, even more preferably 85 parts by mass or less, yet more preferably 80 parts by mass or less, and furthermore preferably 75 parts by mass or less. At or below the upper limit value, the formed article tends to have improved appearance, and the resin composition tends to further improve the fluidity.

The content of the reinforcing material (preferably glass fiber), when contained in the resin composition of this embodiment, is preferably 10% by mass or more in the resin composition, more preferably 15% by mass or more, even more preferably 20% by mass, and yet more preferably 25% by mass or more. Meanwhile, the content of the reinforcing material (preferably glass fiber) is preferably 50% by mass or less in the resin composition, more preferably 45% by mass or less, even more preferably 40% by mass or less, and yet more preferably 35% by mass or less. At or above the lower limit value, the mechanical strength tends to further improve. Meanwhile, at or below the upper limit value, the formed article tends to improve the appearance, and the resin composition tends to further improve the melt fluidity.
The resin composition of this embodiment may contain only one kind of, or two or more kinds of the reinforcing material (preferably glass fiber). When two or more kinds are contained, the total content preferably falls within any of the aforementioned ranges.

<Physical Properties of Resin Composition>

The resin composition of this embodiment preferably demonstrates high absorbance of electromagnetic wave.
More specifically, the resin composition of this embodiment preferably demonstrates an absorbance at 76.5 GHz frequency of 50.0 to 100%, when formed to a thickness of 2 mm (preferably in a size of 100 mm×100 mm×2 mm thick), and determined by Equation (A) .

Equation (A)

$$\text{Absorbance } (\%) = 100 - \left(\frac{1}{10^{-R/10}} \times 100 + \frac{1}{10^{-T/10}} \times 100\right)$$

(In Equation (A), R represents return loss measured by the free space method, and T represents transmission attenuation measured by the free space method.)
The absorbance (at 2 mm thickness) is preferably 53.0% or larger, more preferably 55.0% or larger, even more preferably 58.0% or larger, yet more preferably 60.0% or larger, and furthermore preferably 64.0% or larger. An upper limit value of 90.0% or below, although ideally 100%, may be enough for satisfying performance requirement.
The resin composition of this embodiment also preferably demonstrates an absorbance at 76.5 GHz frequency of 63.0 to 100%, when formed to a thickness of 3 mm (preferably, in a size of 100 mm×100 mm×3 mm thick), and determined by Equation (A).
The absorbance (at 3 mm thickness) is preferably 57.0% or larger, more preferably 59.0% or larger, even more preferably 64.0% or larger, yet more preferably 66.0% or larger, and furthermore preferably 70.0% or larger. An upper limit value of 90.0% or below may be enough for satisfying performance requirement, although ideally 100%.
The resin composition of this embodiment preferably demonstrates low reflectance of electromagnetic wave.
More specifically, the resin composition of this embodiment preferably demonstrates a reflectance at 76.5 GHz frequency of 40.0% or smaller, when formed to a thickness of 2 mm (for example in a size of 100 mm×100 mm×2 mm thick), and determined by Equation (B).

Equation (B)

$$\text{Reflectance } (\%) = \frac{1}{10^{-R/10}} \times 100$$

(In Equation (B), R represents return loss measured by the free space method.)
The reflectance (at 2 mm thickness) is preferably 35.0% or smaller, more preferably 30.0% or smaller, even more preferably 26.0% or smaller, yet more preferably 22.0% or smaller, and furthermore preferably 18.5% or smaller. A lower limit value of 5.0% or above, and further 10.0% or above, is enough for satisfying performance requirement, although ideally 0%.
The resin composition of this embodiment also preferably demonstrates a reflectance at 76.5 GHz frequency of 38.0% or smaller, when formed to a thickness of 3 mm (preferably, in a size of 100 mm×100 mm×3 mm thick), and determined by Equation (B) .

The reflectance (at 3 mm thickness) is preferably 33.0% or smaller, more preferably 28.0% or smaller, even more preferably 24.0% or smaller, yet more preferably 20.0% or smaller, and furthermore preferably 16.5% or smaller. A lower limit value of 3.0% or above, and further 8.0% or above, is enough for satisfying performance requirement, although ideally 0%.
The resin composition of this embodiment preferably demonstrates low transmittance.
The resin composition of this embodiment preferably demonstrates a transmittance at 76.5 GHz frequency of 25.0 or smaller, when formed to a thickness of 2 mm (preferably, in a size of 100 mm×100 mm×2 mm thick), and determined by Equation (C) .

Equation (C)

$$\text{Transmittance}\quad(\%)=\frac{1}{10^{-T/10}}\times 100$$

(In Equation (C), T represents transmission attenuation measured by the free space method.)
The transmittance (at 2 mm thickness) is preferably 23.0% or smaller, and more preferably 20.0% or smaller. A lower limit value of 5.0% or above is enough for satisfying performance requirement, although ideally 0%.
The resin composition of this embodiment also preferably demonstrates a transmittance at 76.5 GHz frequency of 26.0% or smaller, when formed to a thickness of 3 mm (preferably, in a size of 100 mm×100 mm×3 mm thick), and determined by Equation (C) .
The transmittance (at 3 mm thickness) is preferably 24.0% or smaller, and more preferably 21.0% or smaller. A lower limit value of 4.0% or above is enough for satisfying performance requirement, although ideally 0%.
The resin composition of this embodiment preferably satisfies all of the absorbance determined by Equation (A), the reflectance determined by Equation (B), and the transmittance determined by Equation (C).
The resin composition of this embodiment preferably has large dielectric constant. The resin composition of this embodiment also preferably has large dielectric loss tangent.
The resin composition of this embodiment preferably demonstrates a dielectric constant at 76.5 GHz frequency of 4.50 or larger, which is more preferably 4.60 or larger, even more preferably 4.75 or larger, yet more preferably 4.90 or larger, furthermore preferably 5.00 or larger, and again furthermore preferably 5.10 or larger. At or above the lower limit value, the obtainable formed article tends to further elevate the absorbance of electromagnetic wave. Meanwhile, the upper limit value of the dielectric constant is preferably 8.00 or below, more preferably 6.00 or below, even more preferably 5.50 or below, yet more preferably 5.30 or below, and furthermore preferably 5.20 or below. At or below the upper limit value, the obtainable formed article may tend to further lower the reflectance of electromagnetic wave.
The resin composition of this embodiment preferably demonstrates a dielectric loss tangent at 76.5 GHz frequency of 0.10 or larger, which is preferably 0.12 or larger, even more preferably 0.14 or larger, yet more preferably 0.16 or larger, furthermore preferably 0.18 or larger, and again furthermore preferably 0.21 or larger. At or above the lower limit value, the obtainable formed article tends to further elevate the absorbance of electromagnetic wave. The lower limit value of the dielectric loss tangent is typically, but not specifically limited to, 0.50 or below, and may even be 0.40 or below.
At or below the upper limit value, the obtainable formed article may tend to further lower the reflectance of electromagnetic wave.
The resin composition of this embodiment preferably excels in mechanical strength.
In particular, the resin composition of this embodiment preferably excels in tensile strength.
For example, the resin composition of this embodiment preferably demonstrates a maximum tensile strength of 40 MPa or larger, when formed into an ISO multi-purpose test specimen (4 mm thick), and measured in compliance with ISO527-1 and ISO527-2, which is more preferably 50 MPa or larger. A maximum tensile strength of 200 MPa or smaller for example is at the practical level, although the upper limit value is not specifically limited.
The resin composition of this embodiment also preferably demonstrates a tensile modulus of 1500 MPa or larger, when formed into an ISO multi-purpose test specimen (4 mm thick), and measured in compliance with ISO527-1 and ISO527-2, which is more preferably 1500 MPa or larger, even more preferably 1800 MPa or larger, and yet more preferably 2000 MPa or larger. Even a tensile modulus of, for example, 12000 MPa or smaller is at the practical level, although the upper limit thereof is not specifically limited.
Moreover, the resin composition of this embodiment preferably demonstrates a tensile strain of 1.0% or larger, when formed into an ISO multi-purpose test specimen (4 mm thick), and measured in compliance with ISO527-1 and ISO527-2, which is more preferably 2.0% or larger, and even more preferably 3.5% or larger. A tensile strain of 30% or

smaller, for example, is at the practical level, although the upper limit value is not specifically limited.

The resin composition of this embodiment also preferably excels in flexural property.

More specifically, the resin composition of this embodiment preferably demonstrates a flexural strength of 50.0 MPa or larger, when formed into an ISO multi-purpose test specimen (4 mm thick), which is more preferably 70.0 MPa or larger. A flexural strength of 300.0 MPa or smaller, for example, is at the practical level, although the upper limit value is not specifically limited.

Moreover, the resin composition of this embodiment preferably demonstrates a flexural modulus of 1,500 MPa or larger, when formed into an ISO multi-purpose test specimen (4 mm thick), which is more preferably 2,000 MPa or larger. A flexural modulus of 15,000 MPa or smaller, for example, is at the practical level, although the upper limit value is not specifically limited.

Moreover, the resin composition of this embodiment preferably excels in impact resistance.

More specifically, the resin composition of this embodiment preferably demonstrates a notched Charpy impact strength of 2.0 $kJ/m^2$ or larger, when formed into an ISO tensile test specimen (4 mm thick), and measured in compliance with ISO179, which is more preferably 3.0 $kJ/m^2$ or larger, and even more preferably 3.2 $kJ/m^2$ or larger. A notched Charpy impact strength of 50.0 $kJ/m^2$ or smaller, for example, is at the practical level, although the upper limit value is not specifically limited.

The resin composition of this embodiment also preferably demonstrates a surface resistivity of $1.0\times10^8$ Ω or larger, when formed to a thickness of 2 mm (preferably in a size of 100 mm×100 mm×2 mm thick), and measured in compliance with IEC60093, which is more preferably $1.0\times10^3$ Ω or larger, more preferably $1.0\times10^{10}$ Ω or larger, even more preferably $1.0\times10^{11}$ Ω or larger, yet more preferably $1.0\times10^{12}$ Ω or larger, furthermore preferably $1.0\times10^{13}$ Ω or larger, and particularly preferably $1.0\times10^{14}$ Q or larger, meanwhile preferably $1.0\times10^{16}$ Q or smaller, and more preferably $1.0\times10^{15}$ Ω or smaller. Within these ranges, the obtainable formed article tends to further enhance the absorbance of electromagnetic wave.

The resin composition of this embodiment also preferably demonstrates a volume resistivity of $1.0\times10^{10}$ Ω·cm or larger, when formed to a thickness of 2 mm (preferably, in a size of 100 mm×100 mm×2 mm thick), and measured in compliance with IEC60093, which is more preferably $1.0\times10^{11}$ Ω·cm or larger, even more preferably $1.0\times10^{12}$ Ω·cm or larger, yet more preferably $1.0\times10^{13}$ Ω· cm or larger, furthermore preferably $1.0\times10^{14}$ Ω·cm or larger, again furthermore preferably $1.0\times10^{15}$ Ω·cm or larger, meanwhile, preferably $1.0\times10^{17}$ Q-cm or smaller, and more preferably $1.0\times10^{16}$ Ω ·cm or smaller. Within these ranges, the obtainable formed article tends to further enhance the absorbance of electromagnetic wave.

Details of the method of measurement will be detailed in EXAMPLES.

<Another Specific Example of Resin Composition: (1)>

Another specific example (1) of the resin composition of this embodiment relates to a resin composition that contains the polybutylene terephthalate resin, the polystyrene-based resin, and the carbon nanotube.

With such structure, obtainable is a resin composition that demonstrates high absorbance. The reason why is presumably as follows. Blending of the polybutylene terephthalate resin with the carbon nanotube can achieve a certain level of absorbance of electromagnetic wave. In this embodiment, additional blending with the styrene-based resin can make the carbon nanotube more effectively disperse into the polybutylene terephthalate resin, to successfully enhance the absorbance of the obtainable resin composition.

The structure of this embodiment can also reduce the reflectance and transmittance of electromagnetic wave of the resin composition. This can also enhance the tensile property, which is particularly tensile strain.

The aforementioned effect may be more effectively achieved by preliminarily preparing the carbon nanotube in the form of masterbatch in a styrene-based resin, and then by blending the masterbatch with the polybutylene terephthalate resin. The mechanism is presumably because, when melt-kneading the polybutylene terephthalate resin and the masterbatch of the carbon nanotube in styrene-based resin, the carbon nanotube comes out from the styrene-based resin and goes into the polybutylene terephthalate resin by dispersion, during which the driving force can deagglomerate the carbon nanotube, making the carbon nanotube more effectively disperse in the polybutylene terephthalate resin.

On the other hand, such another specific example (1) of the resin composition usually demonstrates a sea-island structure having a sea region where the polybutylene terephthalate resin is abundant, and an island region where the polystyrene-based resin is abundant, in which 30% by mass or more (preferably 45% by mass or more, more preferably 65% by mass or more, and even more preferably 85% by mass or more) of the resin component contained in the resin composition is attributable to the polybutylene terephthalate resin, with the content of the carbon nanotube contained in the sea region set larger than the content of the carbon nanotube contained in the island region. With such mode, the resin composition tends to demonstrate higher absorbance of electromagnetic wave. This sort of sea-island structure is presumably ascribed to that the polybutylene terephthalate resin and the polystyrene-based resin are less compatible, and that the carbon nanotube is intrinsically more compatible with the polybutylene terephthalate resin,

rather than with the polystyrene-based resin.

<Another Specific Example of Resin Composition: (2)>

Another specific example (2) of the resin composition of this embodiment relates to a resin composition that contains a thermoplastic resin and a carbon nanotube, and demonstrates a dielectric constant at 76.5 GHz frequency of 4.50 or larger. With the dielectric constant at 76.5 GHz frequency thus elevated, the obtainable resin composition may have large absorbance of electromagnetic wave around 76.5 GHz wavelength. Additionally with the structure of this embodiment, the resin composition may have lowered reflectance and transmittance of electromagnetic wave at 76.5 GHz frequency.

The absorbance of electromagnetic wave may be improved by elevating the dielectric constant, presumably because the resin composition may have an enhanced effect of shielding the electric field. It is surprising that the resin composition can improve the absorbance, as a result of elevated dielectric constant of the resin composition. Moreover, the absorbance improves also as a result of elevation of the dielectric loss tangent. The absorbance improves as a result of elevation of the dielectric loss tangent, presumably because conversion efficiency from electromagnetic wave to heat energy may improve inside the resin composition.

Possible schemes for elevating the dielectric constant of the resin composition are exemplified by choice of a material having large dielectric constant; possibly minimum use of a material that may lower the dielectric constant; thorough dispersion of a material having large dielectric constant in the resin; and increase of volume fraction of a material having large dielectric constant. In particular, by blending an additive having large dielectric constant with a composition composed of two or more kinds of thermoplastic resin, the obtainable resin composition may have large dielectric constant. Also schemes for elevating the dielectric loss tangent of the resin composition are basically same as the schemes for elevating the dielectric constant. Note that careful choice is occasionally necessary, since some material may elevate the dielectric constant but concurrently lower the dielectric loss tangent.

The thermoplastic resin in this embodiment preferably contains a thermoplastic resin (A) and a thermoplastic resin (B). Note that the thermoplastic resin (A) and the thermoplastic resin (B) may be the same resin.

The content of the thermoplastic resin (B) in the resin composition of this embodiment, per 100 parts by mass of the thermoplastic resin (A), is preferably 1.0 parts by mass or more, more preferably 2.0 parts by mass or more, and even more preferably 2.5 parts by mass or more. At or above the lower limit value, the electromagnetic wave absorbance tends to further improve. Meanwhile, the content of the thermoplastic resin (B), per 100 parts by mass of the thermoplastic resin (A), is preferably 100 parts by mass or less, more preferably 80 parts by mass or less, even more preferably 50 parts by mass or less, yet more preferably 30 parts by mass or less, furthermore preferably 10.0 parts by mass or less, and may even be 8.0 parts by mass less, 7.0 parts by mass or less, and 6.0 parts by mass or less. At or below the upper limit value, the obtainable formed article may tend to further lower the transmittance.

The thermoplastic resin (A) in this embodiment is preferably a major resin that composes the formed article (for example, a component whose content is largest). Moreover, in this embodiment, at least a part of the thermoplastic resin (B) is attributable to a masterbatch of the carbon nanotube. With such structure, the effect of this invention may tend to be demonstrated more effectively.

The resin composition of this embodiment may contain only one kind of each of the thermoplastic resin (A) and the thermoplastic resin (B), or may contain two or more kinds of each of these resins. When two or more kinds are contained, the total content preferably falls within any of the aforementioned ranges.

The thermoplastic resin (A) in this embodiment preferably contains a polyester resin (preferably, polybutylene terephthalate resin). In this embodiment, preferably 95% by mass or more of the thermoplastic resin (A) is attributable to polyester resin, wherein the percentage is more preferably 99% by mass or more.

A preferred case of the thermoplastic resin in this embodiment relates to that each of the thermoplastic resin (A) and the thermoplastic resin (B) contains a polyester resin (preferably, polybutylene terephthalate resin), and a more preferred case relates to that 90% by mass or more (preferably 95% by mass or more, more preferably 99% by mass or more) of the thermoplastic resin is attributable to the polyester resin (preferably, polybutylene terephthalate resin).

A preferred case of the thermoplastic resin in this embodiment relates to that the thermoplastic resin (A) contains a polyester resin (preferably, polybutylene terephthalate resin), and that the thermoplastic resin (B) contains a polystyrene-based resin. In this embodiment, preferably 90% by mass or more, more preferably 95% by mass or more, and even more preferably 99% by mass or more of the thermoplastic resin is formed of the polyester resin (preferably polybutylene terephthalate resin) and the polystyrene-based resin (preferably HIPS, and more preferably butadiene rubber-containing polystyrene).

<Another Specific Example of Resin Composition: (3)>

Another specific example (3) of the resin composition of this embodiment relates to a resin composition that

contains a thermoplastic resin (A), a thermoplastic resin (B), and the carbon nanotube, in which at least a part of the thermoplastic resin (B) is attributable to the masterbatch of the carbon nanotube, and an SP value of the thermoplastic resin (A) is equal to or larger than an SP value of the thermoplastic resin (B) (where, the SP value denotes a solubility parameter).

With such structure, providable is a resin composition that demonstrates high absorbance of electromagnetic wave. The reason why is presumably as follows. That is, a resin having high SP value has a relatively large content of polar group. On the other hand, the carbon nanotube, when melt-kneaded with two or more kinds of resin, tends to be attracted to a resin having the polar group. Hence in a case where the resin in which the carbon nanotube is contained to yield the masterbatch has an SP value larger than an SP value of the major thermoplastic resin, melt-kneading of the masterbatch of the carbon nanotube with the major thermoplastic resin presumably makes the carbon nanotube less likely to disperse in the major thermoplastic resin. With the SP value of the thermoplastic resin (B) in which the carbon nanotube is contained to yield the masterbatch set equal to or smaller than the SP value of the thermoplastic resin (A), this embodiment presumably could make the carbon nanotube more easily migrate from the thermoplastic resin (B) to the thermoplastic resin (A) by inter-phase migration during melt-kneading. In particular, the carbon nanotube was presumably made more notably disperse in the thermoplastic resin (A) during melt-kneading, by setting a difference of 0.1 or lager between the SP value of the thermoplastic resin (A), and the SP value of the thermoplastic resin (B), thus successfully achieving high absorbance of electromagnetic wave.

In such another specific example (3) of the resin composition of this embodiment, the SP value of the thermoplastic resin (A) is equal to or larger than the SP value of the thermoplastic resin (B) (now, the SP value denotes a solubility parameter). With such structure, the carbon nanotube tends to improve the dispersibility into the thermoplastic resin (A).

The difference between the SP value of the thermoplastic resin (A) and the SP value of the thermoplastic resin (B) is 0 or larger, preferably 0.1 or larger, more preferably 0.3 or larger, even more preferably 0.5 or larger, yet more preferably 0.7 or larger, and furthermore preferably 1.0 or larger. Meanwhile, the difference between the SP value of the thermoplastic resin (A) and the SP value of the thermoplastic resin (B) is preferably 8.0 or smaller, more preferably 7.0 or smaller, even more preferably 6.0 or smaller, yet more preferably 5.0 or smaller, and furthermore preferably 4.0 or smaller. At or below the upper limit value, the compatibility during melt-kneading tends to improve.

Such another specific example (3) of the resin composition of this embodiment may contain only one kind, or two or more kinds of each of the thermoplastic resin (A) and the thermoplastic resin (B). When two or more kinds are contained, the total content preferably falls within any of the aforementioned ranges.

In this embodiment, the SP value may be determined by finding the solubility in a solvent whose SP value is already known, followed by calculation with use of Hansen Solubility Parameter in Practice ver.5.0.

The thermoplastic resin (A) in such another specific example (3) of the resin composition of this embodiment is usually the major component of the resin component contained in the resin composition.

The thermoplastic resin used in this embodiment is preferably exemplified by polyester resin (thermoplastic polyester resin); polyamide resin; polycarbonate resin; polystyrene-based resin; polyolefin resin such as polyethylene resin, polypropylene resin, and cyclic cycloolefin resin; polyacetal resin; polyimide resin; polyetherimide resin; polyurethane resin; polyphenylene ether resin; polyphenylene sulfide resin; polysulfone resin; and polymethacrylate resin. The thermoplastic resin is more preferably selected from polyester resin, polycarbonate resin and polyamide resin, more preferably contains polyester resin, and even more preferably contains polybutylene terephthalate resin.

The content of the thermoplastic resin (A), in such another specific example (3) of the resin composition of this embodiment is preferably 30% by mass or more in the resin composition, more preferably 35% by mass or more, even more preferably 40% by mass or more, yet more preferably 45% by mass or more, and furthermore preferably 50% by mass or more. In a case where the resin composition does not contain the reinforcing material, the content of the thermoplastic resin (A) is more preferably 60% by mass or more in the resin composition, even more preferably 70% by mass or more, yet more preferably 80% by mass or more, and furthermore preferably 90% by mass or more. At or above the lower limit value, the fluidity during injection molding tends to further improve. Meanwhile, the content of the thermoplastic resin is preferably 99% by mass or less. In a case where the resin composition contains the reinforcing material, the content of the thermoplastic resin (A) is more preferably 90% by mass or less in the resin composition, even more preferably 80% by mass or less, and yet more preferably 75% by mass or less. At or below the upper limit value, the obtainable formed article tends to further improve the mechanical strength.

Such another specific example (3) of the resin composition of this embodiment contains the thermoplastic resin (B). At least a part of the thermoplastic resin (B) is attributable to the masterbatch of the carbon nanotube. With such structure, the carbon nanotube can more easily migrate from the thermoplastic resin (B) into the thermoplastic resin (A) during melt-kneading, thus improving the dispersibility of the carbon nanotube in the resin composition.

Meanwhile, a part of the thermoplastic resin (B) is not necessarily attributable to the masterbatch of the carbon nanotube.

The thermoplastic resin (B) is selected in relation with the thermoplastic resin (A). That is, the type of the

thermoplastic resin (B) may be properly selected without special limitation, so long as the aforementioned relationship between the SP value of the thermoplastic resin (A) and the SP value of the thermoplastic resin (B) is satisfied.

The thermoplastic resin (B) used in this embodiment is preferably exemplified by polyester resin (thermoplastic polyester resin); polyamide resin; polycarbonate resin; polystyrene-based resin; polyolefin resin such as polyethylene resin, polypropylene resin, and cyclic cycloolefin resin; polyacetal resin; polyimide resin; polyetherimide resin; polyurethane resin; polyphenylene ether resin; polyphenylene sulfide resin; polysulfone resin; and polymethacrylate resin. The thermoplastic resin (B) is more preferably selected from polyester resin, polystyrene-based resin and polyolefin resin, even more preferably selected from polyester resin and polystyrene-based resin, more preferably contains polystyrene-based resin, and even more preferably contains HIPS (preferably butadiene rubber-containing polystyrene).

The content of the thermoplastic resin (B) in such another specific example (3) of the resin composition of this embodiment is preferably 1.0 part by mass or more, per 100 parts by mass of the thermoplastic resin (A), more preferably 2.0 parts by mass or more, and even more preferably 2.5 parts by mass or more. At or above the lower limit value, the absorptivity of electromagnetic wave tends to further improve. Meanwhile, the content of the thermoplastic resin (B), per 100 parts by mass of the thermoplastic resin (A), is preferably 100 parts by mass or less, more preferably 80 parts by mass or less, even more preferably 50 parts by mass or less, yet more preferably 30 parts by mass or less, furthermore preferably 10.0 parts by mass or less, and may be 8.0 parts by mass or less, 7.0 parts by mass or less, and 6.0 parts by mass or less. At or below the upper limit value, the obtainable formed article may tend to further lower the transmittance and the reflectance.

In such another specific example (3) of the resin composition of this embodiment, at least a part of the thermoplastic resin (B) is blended as a resin for preparing the masterbatch.

Concentration of the thermoplastic resin (B) in the masterbatch is preferably 99% by mass or lower, and more preferably 95% by mass or lower, meanwhile preferably 50% by mass or higher, more preferably 60% by mass or higher, even more preferably 70% by mass or higher, and yet more preferably 80% by mass or higher. At or below the upper limit value, and at or above the lower limit value, the carbon nanotube tends to improve the dispersibility into the thermoplastic resin (A).

In a preferred exemplary mode of blending of the thermoplastic resin, in such another specific example (3) of the resin composition of this embodiment, the thermoplastic resin (A) contains the polyester resin (preferably, polybutylene terephthalate resin), and the thermoplastic resin (B) contains the polystyrene-based resin. In this embodiment, preferably 90% by mass or more, more preferably 95% by mass or more, and even more preferably 99% by mass or more of the resin component contained in the resin composition is formed of the polyester resin (preferably polybutylene terephthalate resin) and the polystyrene-based resin (preferably HIPS).

In another preferred exemplary mode of blending of the thermoplastic resin, in such another specific example (3) of the resin composition of this embodiment, the thermoplastic resin (A) contains the polyester resin (preferably, polybutylene terephthalate resin), and the thermoplastic resin (B) contains the polyester resin (preferably, polybutylene terephthalate resin). In such another specific example (3) of the resin composition of this embodiment, preferably 90% by mass or more, more preferably 95% by mass or more, and even more preferably 99% by mass of the resin component contained in the resin composition is formed of the polyester resin (preferably polybutylene terephthalate resin).

<Method for Producing Resin Composition>

The resin composition of this embodiment may be produced by any of ordinary methods for preparing resin composition that contains thermoplastic resin, typically by melt-kneading the thermoplastic resin, the electro-conductive substance, and the optional other component. The electro-conductive substance is preferably blended in the form of masterbatch in the thermoplastic resin. With use of the electro-conductive substance in the form of masterbatch in the thermoplastic resin, the electro-conductive substance may be more effectively dispersed into the thermoplastic resin. The concentration of the electro-conductive substance in the masterbatch is preferably 1% by mass or more, more preferably 5% by mass or more, meanwhile, preferably 50% by mass or less, more preferably 40% by mass or less, even more preferably 30% by mass or less, and yet more preferably 20% by mass or less. At or below the upper limit value, and at or above the lower limit value, the electro-conductive substance tends to further improve the dispersibility into the thermoplastic resin.

To the extruder, the individual components may be preliminarily mixed and then fed en *bloc;* or, the individual components may be fed through a feeder without preliminarily mixing them, or after preliminarily mixing only a part of them. The extruder may be either a single-screw extruder or a twinscrew extruder.

The glass fiber, when blended, is preferably side-fed through a side feeder arranged in the middle of a cylinder of the extruder.

Heating temperature during the melt-kneading is properly selectable usually within the range from 170 to 350°C.

<Method for Manufacturing Formed Article>

The formed article, particularly the electromagnetic wave absorber is formed of the resin composition of this embodiment.

Method for manufacturing the formed article of this embodiment is freely selectable, without special limitation, from known forming/molding methods usually employed for resin composition that includes thermoplastic resin. The method is exemplified by injection molding, ultra-high-speed injection molding, injection compression molding, two color molding, hollow molding such as gas-assisted molding, molding with use of heat insulation dies, molding with use of rapid heating dies, foam molding (including supercritical fluid), insert molding, IMC (in-mold coating) molding, extrusion molding, sheet forming, thermoforming, rotational molding, laminate molding, press molding and blow molding. Among them, injection molding is preferred.

<Applications>

The formed article of this embodiment is formed of the resin composition of this embodiment. The resin composition of this embodiment is preferably intended for use as an electromagnetic wave absorber (also referred to as electromagnetic wave absorbing member), more preferably as an electromagnetic wave absorber adapted to at least the frequency range from 60 to 90 GHz, and even more preferably as an electromagnetic wave absorber adapted to at least the frequency range from 70 to 80 GHz. This sort of electromagnetic wave absorber is preferably applicable to radar, and more specifically to enclosure, cover and so forth for a millimeter-wave radar.

The electromagnetic wave absorber of this embodiment is suitably applicable to vehicle-borne millimeter-wave radar used for automatic brake control device, adaptive cruise control device, pedestrian accident reducing steering device, erroneous start prevention control system, pedal misapplication prevention device, rear vehicle monitoring device, lane keeping assist system, rear-end collision prevention device, parking assist device, and vehicle periphery monitoring device; railroad/aviation radar used for platform monitoring/level crossing obstacle detection device, in-train information content transmitter, tram/railroad collision prevention device, and airport runway foreign object detection device; millimeter-wave radar for traffic infrastructure such as crossing monitor device, and elevator monitor; millimeter-wave radar for various security devices; millimeter-wave for medical/nursing care such as child/elderly monitoring system; and millimeter-wave radar for transmitting various information contents.

EXAMPLES

This invention will further be detailed referring to Examples. All materials, amounts of consumption, proportions, process details and procedures described in Examples below may suitably be modified, without departing from the spirit of this invention. Hence, the scope of this invention is by no means limited to specific Examples below.

In a case where any measuring instrument used in Examples become unavailable typically due to discontinuation, the measurement may be conducted with use of other instrument having equivalent performances.

Raw Materials

Raw materials summarized below were used. In Table 1 below, PBT represents polybutylene terephthalate resin, HIPS represents high impact polystyrene, PA represents polyamide resin, and CNT represents carbon nanotube (the same will apply to Table 2).

[Table 1]

Raw Materials

Raw materials summarized below were used. In Table 1 below, HIPS represents high impact polystyrene, PBT represents polybutylene terephthalate resin, PA represents polyamide resin, and CNT represents carbon nanotube (the same will apply to Table 2) .

[Table 1]

| Raw material | Abbrev. | Detail |
|---|---|---|
| (A) Polybutylene terephthalate resin | (A-1) | PBT, product name: Novaduran (registered trademark) 5008, from Mitsubishi Engineering-Plastics Corporation<br>Intrinsic viscosity: 0.85 dL/g |
| | (A-2) | PBT, product name: Novaduran (registered trademark) 5020, from Mitsubishi Engineering-Plastics Corporation<br>Intrinsic viscosity: 1.20 dL/g |
| | (A-3) | PBT, product name: Novaduran (registered trademark) 5026, from Mitsubishi Engineering-Plastics Corporation<br>Intrinsic viscosity: 1.26 dL/g |
| (B) Carbon nanotube masterbatch | (B-1) | PBT1501, from Nanocyl S.A., CNT concentration = 15% by mass |
| | (B-2) | HIPS1001, from Nanocyl S.A., CNT concentration = 10% by mass |
| | (B-3) | PA1503, from Nanocyl S.A., CNT concentration = 15% by mass |
| (C) Stabilizer | (C-1) | Hindered phenol-based stabilizer<br>Pentaerythritoltetrakis[3-(3,5-di-tert-butyl-4-hydroxyphenyl) propionate]<br>Product name: ADK STAB AO-60, from ADEKA Corporation |
| (D) Mold releasing agent | (D-1) | "Polyethylene-based wax, "Hi-Wax 100P", from Mitsui Chemicals, Inc.<br>Dropping point: 116°C |

The CNT has a diameter (number-average fiber diameter) of 9 nm.

Examples 1, 2, Comparative Example 1

<Production of Resin Composition (Pellet)>

From among the raw materials listed in Table 1, the individual components selected as summarized in Table 2 were placed in a stainless steel tumbler, and mixed under stirring for one hour. The obtained mixture was fed into an intermeshed co-rotation twin screw extruder ("TEX-30α", from Japan Steel Works, Ltd., screw diameter = 32 mm, LID = 42) through a main feeding port. The content was melt-kneaded at a barrel preset temperature in the first kneading zone of 250°C, at a discharge rate of 40 kg/h, and a screw speed of 200 rpm, and then extruded into strands through a four-hole nozzle (4 mm diameter round hole, 1.5 cm long). The extruded strands were introduced into a water bath for cooling, and then inserted to a pelletizer for cutting, to obtain a resin composition (pellet).

<Absorbance, Reflectance, and Transmittance of Electromagnetic Wave at 76.5 GHz>

The obtained pellet was injection-molded with use of an injection molding machine ("NEX80", from Nissei Plastic Industrial Co., Ltd.), at a cylinder preset temperature of 260°C (exceptionally 280°C for Comparative Examples 2-5, 2-6), and a mold temperature of 80°C, to obtain a 100 mm×100 mm×2 mm thick test specimen, and a 100 mm×100 mm×3 mm thick test specimen. With use of the obtained test specimens, the absorbance determined by Equation (A) above, the reflectance determined by Equation (B) above, and, the transmittance determined by Equation (C) above, all at 76.5 GHz frequency, were measured as described below.

A network analyzer "N5252A" from Keysight Technologies was used for the measurement.

For the measurement, the test specimen was placed while aligning the transverse direction of injection-molded article in parallel with the direction of electric field.

Equation (A)

$$\text{Absorbance } (\%) = 100 - \left(\frac{1}{10^{-R/10}} \times 100 + \frac{1}{10^{-T/10}} \times 100\right)$$

(In Equation (A), R represents return loss measured by the free space method, and T represents transmission attenuation measured by the free space method.)

Equation (B)

$$\text{Reflectance}\quad (\%) = \frac{1}{10^{-R/10}} \times 100$$

(In Equation (B), R represents return loss measured by the free space method.)

Equation (C)

$$\text{Transmittance}\quad (\%) = \frac{1}{10^{-T/10}} \times 100$$

(In Equation (C), T represents transmission attenuation measured by the free space method.)

<Dielectric Constant and Dielectric Loss Tangent>

The thus obtained pellet was injection-molded with use of an injection molding machine ("NEX80", from Nissei Plastic Industrial Co., Ltd.), at a cylinder preset temperature of 260°C, and a mold temperature of 80°C, to obtain a 100 mm×100 mm×2 mm thick test specimen.
With use of the obtained test specimen, the dielectric constant and the dielectric loss tangent were determined at 76.5 GHz frequency. The test specimen was measured while aligning the transverse direction (TD) of the injection-molded article in parallel with the direction of electric field.
The measurement was conducted with use of a network analyzer "N5252A" from Keysight Technologies. Values of the dielectric constant and the dielectric loss tangent were estimated with use of N1500A materials measurement software suite from Keysight Technologies, according to a calculation model "NIST Precision".

<Area Percentage of Aggregate>

The thus obtained pellet was injection-molded with use of an injection molding machine ("NEX80", from Nissei Plastic Industrial Co., Ltd.), at a cylinder preset temperature of 260°C, and a mold temperature of 80°C, to obtain a 100 mm×100 mm×2 mm thick test specimen. The test specimen was then mechanically polished to produce a rectangular cross section that contains the center point of the test specimen, oriented perpendicular to the MD direction in the injection molding (direction of resin flow), and measures 15 mm wide in the TD direction in the injection molding (perpendicular to the MD direction), and 2 mm thick. The cross section was produced by preliminarily embedding the test specimen with a curable epoxy resin, and the surface was polished, so as to obtain a smooth surface that properly retains the sample condition, and is suitable for observation under an optical microscope.
The cross section was observed under a digital microscope "VHX-7000" from the Keyence Corporation. When photographing, lighting scheme, image contrast and so forth were properly controlled so that the aggregate attributable to the carbon nanotube may distinctly look dark. The lens used here was a high-resolution medium-magnification objective lens (HR) VHX-E100 for mounting on a microscope head. Images in four fields of view per sample were acquired at 100× magnification.
On the thus obtained images, equivalent circle diameter and area percentage of carbon nanotube aggregate were determined according to the procedures 1, 2, and 3 below, with use of image processing software "WinROOF 2018" from Mitani Corporation.

1. Monochromatic conversion of observed image.
2. Automatic binarization (select carbon nanotube aggregate) (The threshold value was freely set to an appropriate value by the observer, according to the discriminant analysis method.)

3. Calculation of equivalent circle diameter, and averaging of data from images in four fields of view per sample.

(The aggregate whose equivalent circle diameter is smaller than 30 μm was excluded.)

The equivalent circle diameter mentioned herein was calculated by Equivalent circle diameter = (Area percentage of aggregate/$\pi$)$^{1/2}$$\times$2, and the area percentage was calculated by the equation below.

$$\text{Area percentage (\%)} = (\text{total area of CNT aggregate})/(\text{area of observed cross section}) \times 100$$

<Tensile Property>

The thus obtained resin pellet was dried at 120°C for 5 hours, and then injection-molded into an ISO multipurpose test specimen (4 mm thick), with use of an injection molding machine ("J85AD", from Japan Steel Works, Ltd.), at a cylinder temperature of 250°C, and a mold temperature of 80°C.

The thus molded ISO multi-purpose test specimen was subjected to measurement of maximum tensile strength (in MPa), tensile modulus (in MPa) and tensile strain (in %), in compliance with ISO527-1 and ISO527-2.

<Flexural Property>

The thus obtained resin pellet was dried at 120°C for 5 hours, and then injection-molded into an ISO multipurpose test specimen (4 mm thick), with use of an injection molding machine ("J85AD", from Japan Steel Works, Ltd.), at a cylinder temperature of 250°C, and a mold temperature of 80°C.

The thus molded ISO multi-purpose test specimen was subjected to measurement of flexural strength (in MPa) and flexural modulus (in MPa), in compliance with ISO178.

<Notched Charpy Impact Strengths

The thus obtained resin pellet was dried at 120°C for 5 hours, and then injection-molded into an ISO multipurpose test specimen (4 mm thick), with use of an injection molding machine ("J85AD", from Japan Steel Works, Ltd.), at a cylinder temperature of 250°C, and a mold temperature of 80°C.

The thus obtained ISO multi-purpose test specimen was cut into a predetermined size and shape in compliance with ISO179, and subjected to measurement of notched Charpy impact strength. The unit is kJ/m$^2$.

<Surface Resistivity>

The thus obtained pellet was injection-molded with use of an injection molding machine ("NEX80", from Nissei Plastic Industrial Co., Ltd.), at a cylinder preset temperature of 260°C, and a mold temperature of 80°C, to obtain a 100 mm$\times$100 mm$\times$2 mm thick test specimen.

The obtained test specimen was subjected to measurement of surface resistivity (in $\Omega$), in compliance with IEC60093.

For the measurement, "R8340 ultra high resistance meter" from ADVANTEST Corporation was used.

<Volume Resistivity>

The thus obtained pellet was injection-molded with use of an injection molding machine ("NEX80", from Nissei Plastic Industrial Co., Ltd.), at a cylinder preset temperature of 260°C, and a mold temperature of 80°C, to obtain a 100 mm$\times$100 mm$\times$2 mm thick test specimen.

The obtained test specimen was subjected to measurement of volume resistivity (in $\Omega\cdot$cm), in compliance with IEC60093.

For the measurement, "R8340 ultra high resistance meter" from ADVANTEST Corporation was used.

[Table 2]

| | Item | Unit | Example 1 | Example 2 | Comparative Example 1 |
|---|---|---|---|---|---|
| Composition | (A-1) PBT | part by mass | 100.0 | 100.0 | 100.0 |
| | (B-1) PBT1501 | part by mass | 3.6 | | |
| | (B-2) HIPS1001 | part by mass | | 5.3 | |
| | (B-3) PA1503 | part by mass | | | 3.6 |
| | (C-1) Stabilizer | part by mass | 0.2 | 0.2 | 0.2 |
| | (D-1) Mold releasing agent | part by mass | 0.3 | 0.3 | 0.3 |
| | CNT content | % by mass | 0.5 | 0.5 | 0.5 |
| | Resin (A) SP value | - | 20.5 | 20.5 | 20.5 |
| | Resin (B) SP value | - | 20.5 | 18.0 | 21.5 |
| Evaluation | Electromagnetic wave absorbance at 76.5 GHz (2 mm) | % | 63.5 | 67.3 | 47.2 |
| | Electromagnetic wave absorbance at 76.5 GHz (3 mm) | % | 78.1 | 79.0 | |
| | Electromagnetic wave reflectance at 76.5 GHz (2 mm) | % | 19.1 | 16.6 | 2.7 |
| | Electromagnetic wave reflectance at 76.5 GHz (3 mm) | % | 19.2 | 15.6 | |
| | Electromagnetic wave transmittance at 76.5 GHz (2 mm) | % | 17.4 | 16.1 | 50.1 |
| | Electromagnetic wave transmittance at 76.5 GHz (3 mm) | % | 15.9 | 5.4 | |
| | Dielectric constant at 76.5 GHz | - | 5.42 | 5.13 | 4.18 |
| | Dielectric loss tangent at 76.5 GHz | - | 0.20 | 0.22 | 0.09 |
| | Area percentage of aggregate | % | 0.44 | 0.39 | 0.98 |
| | Maximum tensile strength | MPa | 55.8 | 57.0 | 55.5 |
| | Tensile modulus | MPa | 2360 | 2360 | 2450 |
| | Tensile strain | % | 3.0 | 8.9 | 2.7 |
| | Flexural strength | MPa | 94.2 | 91.0 | 91.6 |
| | Flexural modulus | MPa | 2870 | 2880 | 2820 |
| | Notched Charpy impact strength | $kJ/m^2$ | 3.3 | 3.4 | 3.1 |
| | Surface resistivity | Ω | $3.9\times10^{14}$ | $2.8\times10^{14}$ | $1.4\times10^{15}$ |
| | Volume resistivity | Ω · cm | $2.6\times10^{15}$ | $5.4\times10^{15}$ | $1.2\times10^{16}$ |

In Table 2 above, CNT content represents the amount of carbon nanotube in the resin composition.

As is clear from the results above, the resin compositions of this invention were found to demonstrate high

absorbance of electromagnetic wave, as well as low transmittance and low reflectance of electromagnetic wave. The formed articles formed of the resin compositions of this invention were found to excel in the mechanical strength.

<Heat Resistance>

The pellet obtained in Example 1 was formed into a 100 mm×100 mm×2 mm thick test specimen according to the section above titled <Absorbance, Reflectance and Transmittance of Electromagnetic Wave 76.5 GHz>, and subjected to measurement of absorbance, reflectance and transmittance. The 100 mm×100 mm×2 mm thick test specimen was also treated under heating at 180°C in a hot air oven ("DNE400", from Yamato Scientific Co., Ltd.). The test specimens after 500 hours, after 1000 hours, after 1500 hours, and after 2000 hours of heat treatment were subjected to measurement of each of absorbance, reflectance and transmittance according to the section above titled <Absorbance, Reflectance and Transmittance of Electromagnetic Wave 76.5 GHz>. The results were summarized in Table 3, together with data before the treatment (0 hours).

<Hydrolysis Resistance>

The pellet obtained in Example 1 was formed into a 100 mm×100 mm×2 mm thick test specimen according to the section titled <Absorbance, Reflectance and Transmittance of Electromagnetic Wave 76.5 GHz>, and subjected to measurement of absorbance, reflectance and transmittance. The 100 mm×100 mm×2 mm thick test specimen was also allowed to stand still in a highly accelerated stress test system ("EHS-221M", from ESPEC Corporation) at 121°C, a relative humidity of 100%, and 2 atm. The test specimens after 50 hours, after 100 hours, and after 200 hours of the treatment were subjected to measurement of each of absorbance, reflectance and transmittance according to the section titled <Absorbance, Reflectance and Transmittance of Electromagnetic Wave 76.5 GHz>. The results were summarized in Table 3, together with data before the treatment (0 hours).

[Table 3]

| | | 0 hours | 500 hours after | 1500 hours after | 2000 hours after |
|---|---|---|---|---|---|
| Heat resistance | Absorbance | 63.5 | 63.7 | 63.7 | 63.6 |
| | Reflectance | 19.1 | 19.2 | 19.2 | 19.1 |
| | Transmittance | 17.4 | 17.1 | 17.1 | 17.3 |
| Hydrolysis resistance | | 0 hours | 50 hours | 100 hours | 200 hours |
| | Absorbance | 63.5 | 63.8 | 63.9 | 63.8 |
| | Reflectance | 19.1 | 19.1 | 19.1 | 19.2 |
| | Transmittance | 17.4 | 17.1 | 17.0 | 17.0 |

As is clear from the results above, the resin compositions of this invention were found to demonstrate almost no changes in the electromagnetic properties even after prolonged heating. The resin compositions of this invention were also found to excel in the hydrolysis resistance.

Examples 3 to 6

Pellets were obtained in the same way as described in Example 1, except that the individual components described in the section above titled <Production of Resin Composition (Pellet)> were changed as summarized in Table 4.

The thus obtained pellets were then subjected to measurement of absorbance, reflectance, and transmittance according to the section above titled <Absorbance, Reflectance and Transmittance of Electromagnetic Wave 76.5 GHz>.

Next, dielectric constant and dielectric loss tangent were measured according to the section above titled <Dielectric Constant and Dielectric Loss Tangent>. In addition, area percentage of the aggregate was determined according to the section above titled <Area Percentage of Aggregate>.

[Table 4]

| | | Example 3 | Example 4 | Example 5 | Example 6 |
|---|---|---|---|---|---|
| (A-1) PBT | part by mass | | | 50.0 | 100.0 |

(continued)

| | | Example 3 | Example 4 | Example 5 | Example 6 |
|---|---|---|---|---|---|
| (A-2) PBT | part by mass | | 100.0 | 50.0 | |
| (A-3) PBT | part by mass | 100.0 | | | |
| (B-1) PBT1501 | part by mass | 3.6 | 3.6 | 3.6 | 3.6 |
| CNT content | % by mass | 0.5% | 0.5% | 0.5% | 0.5% |
| IV of PBT | dL/g | 1.26 | 1.20 | 1.09 | 0.85 |
| Area percentage of aggregate | % | 0.60 | 0.54 | 0.48 | 0.42 |
| Electromagnetic wave absorbance at 76.5 GHz (2 mm) | % | 57.6 | 57.8 | 61.7 | 64.0 |
| Electromagnetic wave absorbance at 76.5 GHz (3 mm) | % | 71.2 | 71.9 | 74.3 | 78.1 |
| Electromagnetic wave reflectance at 76.5 GHz (2 mm) | % | 25.0 | 24.6 | 23.7 | 19.7 |
| Electromagnetic wave reflectance at 76.5 GHz (3 mm) | % | 23.1 | 23.0 | 21.9 | 19.2 |
| Electromagnetic wave transmittance at 76.5 GHz (2 mm) | % | 17.4 | 17.6 | 14.6 | 16.3 |
| Electromagnetic wave transmittance at 76.5 GHz (3 mm) | % | 18.9 | 18.3 | 16.9 | 15.9 |
| Dielectric constant | - | 5.91 | 5.89 | 5.88 | 5.44 |
| Dielectric loss tangent | - | 0.18 | 0.18 | 0.21 | 0.21 |

The resin compositions of this invention were found to demonstrate excellent absorption property of electromagnetic wave, irrespective of the intrinsic viscosity of the thermoplastic resin, wherein the lower the intrinsic viscosity, the more successfully higher absorbance of the electromagnetic wave was achieved.

## Claims

**1.** A resin composition comprising:

a thermoplastic resin; and
an electro-conductive substance,
the resin composition, when formed to a 2 mm thick test specimen and a cross section thereof is observed under a digital microscope, giving an aggregate attributable to the electro-conductive substance, with an area percentage of the aggregate, having an equivalent circle diameter of 30 μm or larger, of 0.80% or smaller.

**2.** The resin composition of claim 1, wherein the electro-conductive substance contains a carbon nanotube.

**3.** The resin composition of claim 1 or 2, wherein the thermoplastic resin contains a polybutylene terephthalate resin.

**4.** The resin composition of any one of claims 1 to 3, wherein the content of the electro-conductive substance in the resin composition is 0.01 to 10% by mass.

**5.** The resin composition of claim 1, wherein

the thermoplastic resin contains a polybutylene terephthalate resin;
the electro-conductive substance contains a carbon nanotube; and
a content of the electro-conductive substance in the resin composition is 0.01 to 10% by mass.

**6.** The resin composition of claim 1, wherein the thermoplastic resin contains a polybutylene terephthalate resin and a polystyrene-based resin, and
the electro-conductive substance contains a carbon nanotube.

**7.** The resin composition of claim 6, wherein a content of the carbon nanotube in the resin composition is 0.01 to 10% by mass.

**8.** The resin composition of claim 6 or 7, wherein the resin composition demonstrates a sea-island structure having a sea region where the polybutylene terephthalate resin is abundant, and an island region where the polystyrene-based resin is abundant, in which 30% by mass or more of the resin component contained in the resin composition is attributable to the polybutylene terephthalate resin, and
a content of the carbon nanotube contained in the sea region is larger than the content of the carbon nanotube contained in the island region.

**9.** The resin composition of any one of claims 6 to 8, wherein a polystyrene-based resin is attributable to a masterbatch of the carbon nanotube.

**10.** The resin composition of any one of claims 1 to 9, wherein the electro-conductive substance contains a carbon nanotube, and
the resin composition demonstrates a dielectric constant at 76.5 GHz frequency of 4.50 or larger.

**11.** The resin composition of claim 10, demonstrating a dielectric loss tangent at 76.5 GHz frequency of 0.10 or larger.

**12.** The resin composition of claim 10 or 11, wherein the content of the carbon nanotube in the resin composition is 0.01 to 10% by mass.

**13.** The resin composition of any one of claims 10 to 12, wherein the thermoplastic resin contains a thermoplastic resin (A) and a thermoplastic resin (B), with a content of the thermoplastic resin (B) of 1.0 to 100 parts by mass, per 100 parts by mass of the thermoplastic resin (A).

**14.** The resin composition of claim 13, wherein the thermoplastic resin (A) contains a polyester resin.

**15.** The resin composition of claim 14, wherein the polyester resin contains a polybutylene terephthalate resin.

**16.** The resin composition of any one of claims 13 to 15,
wherein the thermoplastic resin (B) contains a polystyrene-based resin.

**17.** The resin composition of any one of claims 13 to 16, wherein at least a part of the thermoplastic resin (B) is attributable to a masterbatch of the carbon nanotube.

**18.** The resin composition of claim 17, wherein a concentration of the carbon nanotube in the masterbatch is 1 to 50% by mass.

**19.** The resin composition of any one of claims 1 to 18, demonstrating an absorbance at 76.5 GHz frequency of 50.0 to 100%, when formed to a thickness of 2 mm, and determined by Equation (A):

Equation (A)

$$\text{Absorbance } (\%) = 100 - \left(\frac{1}{10^{-R/10}} \times 100 + \frac{1}{10^{-T/10}} \times 100\right)$$

(in Equation (A), R represents return loss measured by the free space method, and T represents transmission

attenuation measured by the free space method).

**20.** The resin composition of any one of claims 1 to 19, demonstrating a reflectance at 76.5 GHz frequency of 40.0% or smaller, when formed to a thickness of 2 mm, and determined by Equation (B):

Equation (B)

$$\text{Reflectance}\quad (\%) = \frac{1}{10^{-R/10}} \times 100$$

(in Equation (B), R represents return loss measured by the free space method).

**21.** The resin composition of any one of claims 1 to 20, demonstrating a transmittance at 76.5 GHz frequency of 25.0% or smaller, when formed to a thickness of 2 mm, and determined by Equation (C):

Equation (C)

$$\text{Transmittance}\quad (\%) = \frac{1}{10^{-T/10}} \times 100$$

(in Equation (C), T represents transmission attenuation measured by the free space method).

**22.** The resin composition of any one of claims 1 to 21, demonstrating a surface resistivity of $1.0 \times 10^{8}\ \Omega$ or larger, when formed to a thickness of 2 mm, and measured in compliance with IEC60093.

**23.** The resin composition of any one of claims 1 to 22, used for an electromagnetic wave absorber.

**24.** A formed article formed of the resin composition described in any one of claims 1 to 23.

**25.** An electromagnetic wave absorber formed of a resin composition described in any one of claims 1 to 23.

**26.** A method for producing a resin composition, the method comprising melt-kneading a polybutylene terephthalate resin, and a masterbatch of a carbon nanotube in a styrene-based resin.

**27.** The method for producing a resin composition of claim 26, wherein the resin composition is a resin composition described in any one of claims 6 to 9.

**28.** The method for producing a resin composition of any one of claims 10 to 18, the method comprising melt-kneading the thermoplastic resin, and the masterbatch of the carbon nanotube in the thermoplastic resin.

[Fig. 1]

(a)

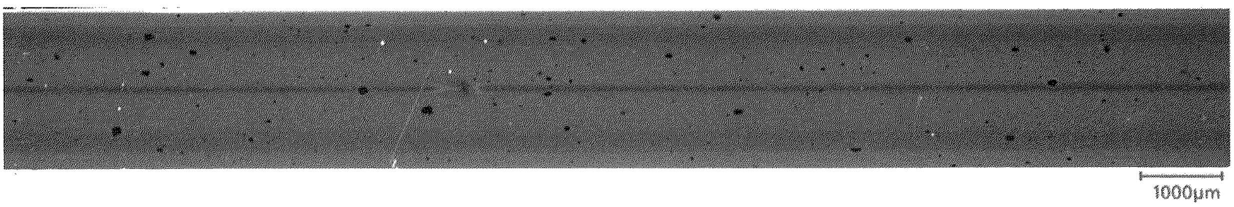


(b)

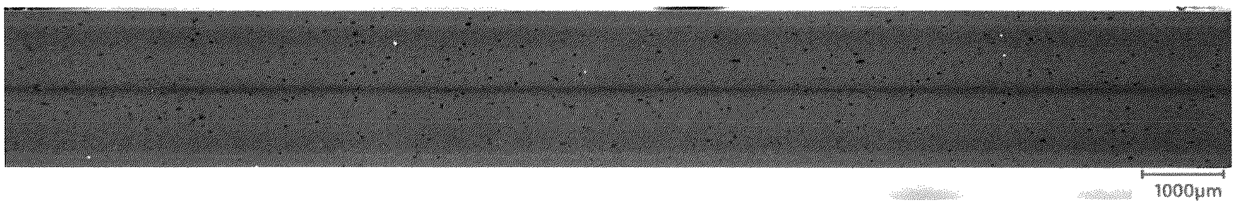


(C)

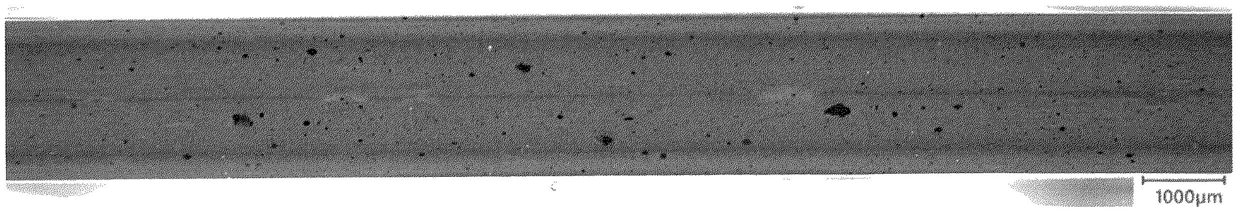

**INTERNATIONAL SEARCH REPORT**

International application No. **PCT/JP2022/007629**

**A. CLASSIFICATION OF SUBJECT MATTER**

***C08J 3/22***(2006.01)i; ***C08K 7/06***(2006.01)i; ***C08L 25/04***(2006.01)i; ***C08L 67/02***(2006.01)i; ***C08L 101/00***(2006.01)i; ***C08J 5/18***(2006.01)i; ***H01B 1/24***(2006.01)i; ***H01B 5/16***(2006.01)i; ***C08K 3/01***(2018.01)i; ***C08K 3/04***(2006.01)i; ***H05K 9/00***(2006.01)i

FI: C08L101/00; C08L67/02; C08K3/04; C08L25/04; H05K9/00 M; C08K7/06; C08K3/01; H01B1/24 A; H01B5/16; C08J3/22 CFG; C08J5/18 CFD

According to International Patent Classification (IPC) or to both national classification and IPC

**B. FIELDS SEARCHED**

Minimum documentation searched (classification system followed by classification symbols)

C08J3/22; C08K7/06; C08L25/04; C08L67/02; C08L101/00; C08J5/18; H01B1/24; H01B5/16; C08K3/01; C08K3/04; H05K9/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2003-100147 A (NAGASE & CO., LTD.) 04 April 2003 (2003-04-04)<br>examples, comparative examples, etc. | 1-5, 19-25<br>6-18, 26-28 |
| X<br>A | JP 2018-21117 A (KATANO SENKAKU KK) 08 February 2018 (2018-02-08)<br>examples 1-12, comparative examples 4, 5, 7, 8, etc. | 1-5, 19-25<br>6-18, 26-28 |
| X<br>A | JP 2009-197056 A (TEIJIN CHEM. LTD.) 03 September 2009 (2009-09-03)<br>examples 1, 2, 6-10, comparative examples 1, 2, etc. | 1-5, 19-25<br>6-18, 26-28 |
| X<br>A | JP 2005-162814 A (TOSOH CORP.) 23 June 2005 (2005-06-23)<br>example 3, etc. | 1-5, 19-25<br>6-18, 26-28 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **21 April 2022** | **10 May 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**

International application No.
**PCT/JP2022/007629**

**C. DOCUMENTS CONSIDERED TO BE RELEVANT**

| Category* | Citation of document, with indication, where appropriate, of the relevant passages | Relevant to claim No. |
|---|---|---|
| X | WO 2019/167854 A1 (MITSUBISHI ENGINEERING-PLASTICS CORP.) 06 September 2019 (2019-09-06)<br>examples 1-22, comparative examples 3-7, 11-14, etc. | 1-2, 4, 19-25 |
| A | | 3, 5-18, 26-28 |

Form PCT/ISA/210 (second sheet) (January 2015)

**INTERNATIONAL SEARCH REPORT**
**Information on patent family members**

International application No.
**PCT/JP2022/007629**

| Patent document cited in search report | Publication date (day/month/year) | Patent family member(s) | Publication date (day/month/year) |
|---|---|---|---|
| JP 2003-100147 A | 04 April 2003 | (Family: none) | |
| JP 2018-21117 A | 08 February 2018 | (Family: none) | |
| JP 2009-197056 A | 03 September 2009 | CN 101514257 A | |
| JP 2005-162814 A | 23 June 2005 | (Family: none) | |
| WO 2019/167854 A1 | 06 September 2019 | US 2021/0032461 A1<br>examples 1-22, comparative examples 3-7, 11-14, etc.<br>EP 3760762 A1<br>CN 111771013 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2019197048 A
- JP 2010155993 A
- JP 2010174223 A
- JP 2005344065 A
- JP 2011132550 A
- JP 2018070722 A
- JP 2019056035 A
- WO 2017038949 A